# EUROPEAN PATENT SPECIFICATION

(11) **EP 3 516 096 B1**
(45) Date of publication and mention of the grant of the patent: **09.09.2026**
(21) Application number: 17853869.0
(22) Date of filing: 21.09.2017
(51) Int. Cl.: C25D 3/38, C25D 3/00, C25D 3/02, C25D 7/12, C25D 5/18, C25D 17/00, C25D 17/02, C25D 21/02

(54) **COPPER ELECTRODEPOSITION IN MICROELECTRONICS**
GALVANISCHE KUPFERABSCHEIDUNG IN MIKROELEKTRONIK
ÉLECTRODÉPOSITION DE CUIVRE EN MICROÉLECTRONIQUE

(30) Priority: 22.09.2016 US 201662398294 P
(43) Date of publication of application: 31.07.2019
(73) Proprietor: MacDermid Enthone Inc., Waterbury, CT 06702 (US)
(72) Inventor: PANECCASIO, Vincent, Madison, CT 06643 (US); WHITTEN, Kyle, Hamden, CT 06514 (US); HURTUBISE, Richard, Clinton, CT 06413 (US); COMMANDER, John, Old Saybrook, CT 06475 (US); ROUYA, Eric, Oakland, CA 94607 (US)
(74) Representative: Novagraaf Group
(86) International application number: PCT/US2017/052668
(87) International publication number: WO 2018/057707

(56) References cited:
- WO-A1-2010/115757
- US-A1- 2007 289 875
- US-A1- 2010 126 872
- US-A1- 2010 126 872
- US-A1- 2012 018 310
- US-A1- 2012 018 310
- US-A1- 2013 098 770
- US-A1- 2014 197 038
- US-A1- 2016 076 160

## Description

### FIELD OF THE INVENTION

This invention relates generally to compositions for electrolytic copper metallization in the field of microelectronics manufacture, and in particular to electrolytic plating composition for superfilling submicron features in a semiconductive integrated circuit device.

### BACKGROUND OF THE INVENTION

Electrolytic copper metallization is employed in the field of microelectronics manufacture to provide electrical interconnection in a wide variety of applications, including, for example, manufacturing semiconductor integrated circuit (IC) devices. The demand for semiconductor IC devices, such as computer chips with high circuit speed and high packing density, requires the downward scaling of feature sizes in ultra-large-scale integration (ULSI) and very-large-scale integration (VLSI) structures. The trend to smaller device sizes and increased circuit density requires decreasing the dimensions of interconnect features. An interconnect feature is a feature such as a via or trench formed in a dielectric substrate which is then filled with metal to yield an electrically conductive interconnect. Further decreases in interconnect size present challenges in metal filling.

Copper has been used to replace aluminum to form connection lines and interconnects in semiconductor substrates. Copper has a lower resistivity than aluminum and the thickness of a copper line for the same resistance can be thinner than that of a corresponding aluminum line.

However, the use of copper has introduced a number of requirements into the IC manufacturing process. First, copper has a tendency to diffuse into the semiconductor's junctions, thereby disturbing their electrical characteristics. To combat this occurrence, a barrier layer, such as titanium nitride, tantalum, tantalum nitride, or other layers as are known in the art, is applied to the dielectric prior to the deposition of the copper layer. It is also generally necessary that the copper be deposited on the barrier layer cost-effectively while ensuring the requisite coverage thickness for carrying signals between the IC's devices. However, as the architecture of ICs continues to shrink, this requirement has been increasingly difficult to satisfy.

One conventional semiconductor manufacturing process is the copper damascene system, which begins by etching the circuit architecture into the substrate's dielectric material. The architecture comprises a combination of the aforementioned trenches and vias. Next, a barrier layer is laid over the dielectric to prevent diffusion of the subsequently applied copper layer into the substrate's junctions, followed by physical or chemical vapor deposition of a copper seed layer, to provide electrical conductivity for a sequential electrochemical process. Copper to fill into the vias and trenches on substrates can be deposited by plating (such as electroless and electrolytic), sputtering, plasma vapor deposition (PVD), and chemical vapor deposition (CVD).

Electrochemical deposition is a preferred method for applying copper since it is more economical than other deposition methods and can flawlessly fill into the interconnect features (often called "bottom up" growth). After the copper layer has been deposited, excess copper is removed from the facial plane of the dielectric by chemical mechanical polishing, leaving copper in only the etched interconnect features of the dielectric. Subsequent layers are similarly produced before assembly into the final semiconductor package.

Copper plating methods must meet the stringent requirements of the semiconductor industry. For example, copper deposits must be uniform and capable of flawlessly filling the small interconnect features of the device, such as those with openings of 100 nm or smaller.

Electrolytic copper systems have been developed which rely on so-called "superfilling" or "bottom-up growth" to deposit copper into high aspect ratio features. Superfilling involves filling a feature from the bottom up, rather than at an equal rate on all its surfaces, to avoid seams and pinching off that can result in voiding. Systems comprising a suppressor and an accelerator as additives have been developed for superfilling. As the result of momentum of bottom-up growth, the copper deposit is thicker on the areas of interconnect features than on the field area that does not have features. These overgrowth regions are commonly called overplating, mounding, bumps, or humps. Smaller features generate higher overplating humps due to faster superfill speed. Overplating poses challenges for later chemical and mechanical polishing processes that planarize the copper surface. Various additives, including levelers, can be used to reduce the overgrowth.

As chip architecture gets smaller, with interconnects having openings on the order of 100 nm and smaller through which copper must grow to fill the interconnects, there is a need for enhanced bottom-up speed. That is, the copper must fill "faster" in the sense that the rate of growth on the feature bottom must be substantially greater than the rate of growth on the rest of areas, and even more so than in conventional superfilling of larger interconnects.

In addition to superfilling and overplating issues, micro-defects may form when electrodepositing copper for filling interconnect features. One such defect is the formation of internal voids inside the features. As copper is deposited on the feature side walls and top entry of the feature, deposition on the side walls and entrance to the feature can pinch off and thereby close access to the depths of the features, especially with features that are small (e.g., <100 nm) and/or that have a high aspect ratio (depth: width) if the bottom-up growth rate is not fast enough. Smaller feature size or higher aspect ratio generally requires faster bottom-up speed to avoid pinching off. Moreover, smaller size or higher aspect ratio features tend to have thinner seed coverage on the sidewall and bottom of a via/trench where voids can also be produced due to insufficient copper growth in these areas. An internal void can interfere with electrical connectivity through the feature.

Microvoids are another type of defect which can form during or after electrolytic copper deposition due to uneven copper growth or grain recrystallization that happens after copper plating.

Additionally, some local areas of a semiconductor substrate, such as areas where there is a copper seed layer deposited by physical vapor deposition, may not grow copper during the electrolytic deposition, resulting in pits or missing metal defects. These copper voids are considered to be "killer defects," as they reduce the yield of semiconductor manufacturing products. Multiple mechanisms contribute to the formation of these copper voids, including the semiconductor substrate itself. However, copper electroplating chemistry has influence on the occurrence and population of these defects.

Other defects include, for example, surface protrusions, which are isolated deposition peaks occurring at localized high current density sites, localized impurity sites, or otherwise. Copper plating chemistry has an influence on the occurrence of such protrusion defects. Although not considered as defects, copper surface roughness is also important for semiconductor wafer manufacturing. Generally, a bright copper surface is desired as it can reduce the swirl patterns formed during wafer entry in the plating solution. Roughness of copper deposits makes it more difficult to detect defects by inspection, as defects may be concealed by peaks and valleys of rough surface topography. Moreover, smooth growth of copper has become more important for flawlessly filling of fine interconnect structures as the roughness can cause pinch off of feature and thereby close access to the depths of the feature. It is generally recognized that copper plating chemistry, including suppressor, accelerator, and leveler, has great influence on the roughness of copper deposits.

A superior suppressor for use in superfilling of submicron features of a semiconductor substrate by electrodeposition of copper is described in Paneccasio US patent 7,303,992 B2 and US 2007/0289875 A1. The suppressor comprising a combination of propylene oxide (PO) repeat units and ethylene oxide (EO) repeat units present in a PO:EO ratio between about 1:9 and about 9:1 and bonded to a nitrogen-containing species, wherein the molecular weight of the suppressor compound is between about 1000 and about 30,000.

Published applications of BASF, US 2012/0018310 A1, WO 2010/115757 A1, US 2012/0024711 A1 and US 2012/0027948 A1, describe amines having at least three active amine sites substituted with random copolymers of PO and EO.

### SUMMARY

The present invention provides an electrolytic plating composition for superfilling submicron features in a semiconductive integrated circuit device according to claim 1. Preferred or optional features are defined in dependent claims 2.13. Described herein are electrodeposition compositions comprising a source of copper ions, in an amount sufficient to electrolytically deposit copper onto the substrate and into the electrical interconnect features, and a suppressor comprising a polyether bonded to a nitrogen of an oligo(alkylene imine) having at least three amine sites. The polyether comprises a block copolymer substituent comprising propylene oxide (PO) repeat units and ethylene oxide (EO) repeat units, preferably wherein the ratio of propylene oxide (PO) repeat units to ethylene oxide (PO) repeat units is adjusted to balance the strongly polarizing effect of the PO repeat units with the more hydrophilic and solubilizing effect of the EO repeat units. The number average molecular weight of the suppressor compound is between 6,000 and 12,000, preferably between 6,500 and 10,000.

In accordance with the present invention, the alkoxylated oligo(alkylene imine) suppressor corresponds to the structure: 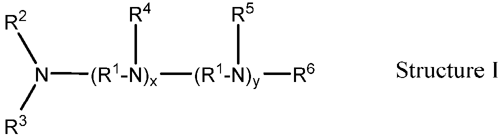 wherein x is an integer between 0 and 4, y is an integer between 0 and 4, x+y is an integer between 2 and 6, R¹ comprises an alkylene group, at least one of R¹, R², R³, R⁴, R⁵ and R⁶ comprises a polyether substituent comprising a block copolymer of propylene oxide and ethylene oxide, wherein a linear portion of the polyether substituent comprises a block of EO repeat units bonded to a block of PO repeat units. The ratio of ethylene oxide (EO) repeat units to propylene oxide (PO) repeat units in at least one polyether substituent is preferably between 2:8 and 7:3, e.g., between 0.25:1 and 1.4:1. Each of the remainder of R¹, R², R³, R⁴, R⁵ and R⁶ is independently selected from the group consisting of hydrogen, lower alkyl, aminoalkyl, hydroxyalkyl, and a polyether substituent comprising propylene oxide (PO) repeat units, ethylene oxide (EO) repeat units, or a combination of PO and EO repeat units. The number average molecular weight of the suppressor compound is between 6,000 and 12,000. In accordance with the invention, the concentration of the suppressor in the electrolytic plating composition is between 50 and 200 mg/L. Preferably, the composition comprises a leveler.

In particularly preferred embodiments of the electrolytic deposition composition, the value of x+y in the suppressor structure: 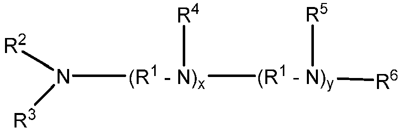 is between 3 and 6 inclusive, the ratio of propylene oxide (PO) to ethylene oxide (EO) repeat units in the block copolymer polyether substituents is between 3:7 and 7:3, and the number average molecular weight is between 6,000 and 12,000.

In further preferred embodiments, the value of x+y is between 2 and 6, the electrolytic composition comprises an oligomeric or polymeric dipyridyl leveler, the ratio of PO to EO is between 2:8 and 7:3, and the molecular weight is between 6,000 and 12,000.

Also disclosed herein are processes for electrolytically plating copper onto a substrate employing any of the foregoing compositions. More particularly disclosed are processes for electroplating a copper deposit onto a semiconductor integrated circuit device substrate with electrical interconnect features including submicron-sized features having bottoms, sidewalls, and top openings. The process comprises: immersing the semiconductor integrated circuit device substrate including submicron-sized features having bottoms, sidewalls, and top openings wherein the submicron-sized features include high aspect ratio features having aspect ratios of at least about 3:1 into an electrolytic plating bath having the composition described above, and supplying electrical current to the electrolytic composition to deposit copper onto the substrate and superfill the submicron-sized features by rapid bottom-up deposition at a rate of growth in the vertical direction which is greater than a rate of growth in the horizontal direction.

Preferably, the electrodeposition composition comprises an accelerator and also preferably comprises a leveler. Upon supply of electrical current to the electrolytic composition, copper deposits onto the substrate and superfills the submicron-sized features by rapid bottom-up deposition at a vertical copper deposition growth rate from the bottoms of the features to the top openings of the features which is greater than 50 % faster than a comparable vertical copper deposition growth rate of comparable process which is equivalent in all respects except that it employs a commercially available suppressor.

Other objects and features will be in part apparent and in part pointed out hereinafter.

### BRIEF DESCRIPTION OF THE FIGURES

Figure 1 depicts a graphical representation of void counts for various suppressors of Example 1 in the dense region.
Figures 2 depicts a graphical representation of void counts for various suppressors of Example 1 in the ISO region.
Figures 3 depicts a graphical representation of void counts for various suppressors of Example 1 for the sum of dense and ISO void counts.
Figure 4 depicts the average results in the dense region for the various suppressors of Example 1.
Figure 5 depicts the average results in the ISO region for the various suppressors of Example 1.
Figure 6 depicts a graphical representation of the prevalence of voids in the center versus the edge of the dense region for the various suppressors of Example 1.
Figure 7 depicts the differences between the edge and center voids of Example 1.
Figure 8 depicts a graphical representation of void counts for various suppressors of Example 2 in the dense region.
Figure 9 depicts a graphical representation of void counts for various suppressors of Example 2 in the ISO region.
Figure 10 depicts a graphical representation of void counts for various suppressors of Example 2 for the sum of dense and ISO void counts.
Figure 11 depicts a graphical representation of the prevalence of voids in the center versus the edge of the dense region for the various suppressors of Example 2.
Figure 12 depicts the differences between the edge and center voids of Example 1.

### DETAILED DESCRIPTION

The present invention relates generally to compositions that are suitable for plating semiconductor integrated circuit substrates having challenging fill characteristics, including interconnect features that are poorly seeded or not substantially seeded, interconnect features having a complex geometry, and large diameter interconnect features as well as small diameter features (less than about 0.5 µm or even substantially smaller, e.g., less than 200 nm, less than 100 nm, less than 50 nm, less than 25 nm, less than 20 nm, less than 15 nm, or even less than 10 nm), and features with high aspect ratios (at least about 3:1) or low aspect ratios (less than about 3:1) where copper must fill all the features completely and substantially defect-free. The process is particularly useful for filling features that have an entry dimension of 5 to 20 nm and an aspect ratio greater than 3:1, e.g., between about 4:1 and about 10:1), and features with high aspect ratios (at least about 3:1) or low aspect ratios (less than about 3:1) where copper must fill all the features completely and substantially defect-free.

The compositions for copper superfilling of semiconductor integrated circuit substrates having challenging fill characteristics of the present invention generally comprise a suppressor compound and a source of copper ions. These compositions may also optionally, but preferably, comprise one or more levelers, one or more accelerators, and/or chloride. The above-listed additives find application in high copper metal/low acid electrolytic plating baths, in low copper metal/high acid electrolytic plating baths, and in mid acid/high copper metal electrolytic plating baths. The compositions described herein can also comprise other additives which are known in the art including halides, grain refiners, quaternary amines, and polysulfide compounds, by way of example and not limitation. Compositions comprising the suppressor, leveler, and accelerator described herein can be used to fill small diameter/high aspect ratio features.

Preferred suppressors for use in the copper plating compositions of the present invention comprise polyether groups covalently bonded to a cationic species. The cationic polyether suppressor comprises a nitrogen atom. Exemplary cationic species comprising a nitrogen atom include primary, secondary, tertiary, and quaternary amines. By "cationic" what is meant is that the polyether suppressor either contains or can contain a positive charge in solution. Primary, secondary, and tertiary amines are weakly basic and become protonated and positively charged when added to a solution comprising an acid. Quaternary amines comprise four nitrogen-substituents, and a quaternized nitrogen possesses a positive charge regardless of the solution pH. The primary, secondary, tertiary, and quaternary amines can be substituted or unsubstituted alkyl amines, substituted or unsubstituted cycloalkyl amines, substituted or unsubstituted aromatic amines, substituted or unsubstituted heteroaryl amines, substituted or unsubstituted alkylether amines, and substituted or unsubstituted aromatic alkyl amines.

The suppressors used in the electrodeposition composition of the present invention, and in a process using such a composition, generally comprise alkoxylated oligo(alkylene imines), such as, for example, alkoxylated diethylene triamine or alkoxylated triethylene tetramine wherein poly(oxyalkylene) polyether groups are covalently bonded to a cationic nitrogen, and are preferably prepared by reaction of alkylene oxides with the oligo(alklene imine) substrate whose residue constitutes the core amine structure of the suppressor. The substrate amine comprises at least three amine functional groups, preferably at least four amine functional groups, and typically up to seven amine functional groups. More particularly, the substrate amine that is alkoxylated to form the suppressor corresponds to the structure: 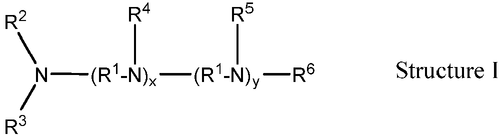 wherein x is an integer between 0 and 4, y is an integer between 0 and 4, x+y is an integer between 2 and 6, R¹ comprises an alkylene group, at least one of R², R³, R⁴, R⁵ and R⁶ comprises a polyether substituent comprising a block copolymer of propylene oxide and ethylene oxide, wherein a linear portion of the polyether substituent comprises a block of EO repeat units bonded to a block of PO repeat units. The ratio of ethylene oxide (EO) repeat units to propylene oxide (PO) repeat units in at least one polyether substituent is preferably between 2:8 and 7:3, e.g., between 0.25:1 and 1.4:1. Each of the remainder of R², R³, R⁴, R⁵ and R⁶ is independently selected from the group consisting of hydrogen, lower alkyl, aminoalkyl, hydroxyalkyl, and a polyether substituent comprising propylene oxide (PO) repeat units, ethylene oxide (EO) repeat units, or a combination of PO and EO repeat units. The number average molecular weight of the suppressor compound is between 6,000 and 12,000.

In one embodiment, the suppressor can correspond to the structure: 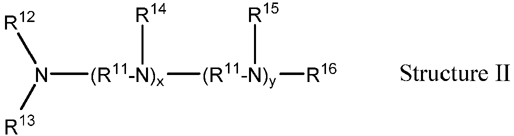 wherein x is an integer between 0 and 4, y is an integer between 0 and 4 and x+y is an integer between 2 and 6, R¹¹ is alkylene, preferably at least two, more preferably at least three, of R¹², R¹³, R¹⁴, R¹⁵ and R¹⁶ are hydrogen, and the remainder of R¹², R¹³, R¹⁴, R¹⁵ and R¹⁶ are independently either hydrogen, alkyl, aminoalkyl or hydroxyalkyl. Preferably, each of R¹², R¹³, R¹⁴, R¹⁵ and R¹⁶ in the oligo(alkylene imine) substrate is hydrogen. Alkoxylation of the amine substrate with propylene oxide (PO) and ethylene oxide (EO) provides the polyether substituents of the suppressor used in the electrodeposition process described herein. Particularly preferred amine substrates include diethylene triamine, triethylene tetramine, and tetraethylene pentamine, i.e., where x+y has a value of 2, 3 or 4. For many applications, triethylene tetramine is especially preferred.

In the polyether chain produced by copolymerization of both ethylene oxide monomer and propylene oxide monomers, it is generally preferred that the molar ratio of PO to EO is between 2:8 and 7:3, more preferably between about 0.25:1 and about 1.4:1. A relatively low PO/EO ratio enhances the solubility of the suppressor, increases the cloud point, and, in the course of the electrodeposition process, provides enhanced uniformity of the copper deposit. In particular, the presence of EO units helps minimize formation of defects such as swirl patterns in the copper deposit formed during wafer entry into the plating solution. A relatively high EO content also serves to mitigate the polarization strength which is greatly increased by the use of an alkoxylated diethylene triamine or triethylene tetramine as compared to a conventional alkoxylated ethylene diamine as the core amine. Without being bound to a particular theory, it is thought that the enhanced affinity for the negative polarity of the cathode that is provided by the polyamine core structure allows for a higher relative EO content in the polyether substituent, thus enhancing solubility in the aqueous medium as well. However, it is preferred that the EO content not be too high, because it may unduly compromise the desired enhancement in polarization strength provided by use of the higher amine core structure of the suppressor. In applications where it is desirable to modulate the polarizing effect of the suppressor, a PO/EO ratio in the range of 0.25:1 to 1.1:1, e.g., in the range of 1:3 to 1.0:1 or in the range of 3:7 to 6:5 may be preferred. Where somewhat stronger polarization is preferred, a suitable PO/EO ratio in the range of 4:6 to 6:4 or even 1.0:1 to 1.4:1.

In accordance with the invention, the number average molecular weight of the suppressor is between 6,000 and 12,000, most preferably between 6,500 and 10,000, especially in those embodiments wherein the value of x+y is 2, i.e., where the core amine is diethylene triamine.

The polyether comprises EO repeat units and PO repeat units in a block configuration. Alternatively, in polyethers in suppressor compounds not according to the present invention in a random configuration, the EO repeat units and PO repeat units have no discernible linear pattern along the polyether chain; and in an alternating configuration, the EO repeat units and PO repeat units alternate according to some defined pattern, such as repeating units of EO-PO, PO-EO, and other alternating patterns. In the block configuration in polyethers in suppressor compounds not according to the present invention, the linear portion of the polyether chain comprises a block of EO repeat units bonded to a block of PO repeat units. The polyether chain may comprise a diblock. That is, the chain may comprise a first block of EO repeat units bonded to a second block of PO repeat units. Alternatively, the chain may comprise a first block of PO repeat units bonded to a second block of EO repeat units. In more complicated block configurations, the polyether chain may comprise a triblock (EO block-PO block-EO block or PO block-EO block-PO block), tetrablock, pentablock, or higher block arrangements. It has been discovered that a PO block-EO block-PO triblock configuration is effective to reduce polyether suppressor foaming in electrolytic solution. Where the polyether chain is in block copolymer configuration, each block of repeat units comprises between 1 and 0 repeat units, more preferably between 7 and 15 repeat units, especially in those embodiments in which the molecular weight of the suppressor is between 6,000 and 12,000. In a preferred embodiment involving a PO block-EO block-PO block tri-block configuration, the first PO-block bonded to the nitrogen (terminal interior block) comprises a single PO unit, or alternatively up to about 7 or as many as 15 PO repeat units, the second EO-block bonded to the PO-block comprises between 7 and 15 repeat units, and the third (terminal exterior) PO-block bonded to the second EO-block comprises between 5 and 20 repeat units.

As noted above, the polyether may comprise only two blocks, e.g., a terminal interior PO block and a terminal exterior EO block, or may comprise a tri-block or a series of four or more blocks. To enhance solubility, provide a relatively high cloud point, and modulate suppression, the polyether substituents of the suppressor may, e.g., comprises a terminal exterior block comprising at least 5, more preferably at least 10, ethylene oxide (EO) repeat units bonded to a relatively more interior block comprising at least 5, more preferably at least 10, propylene oxide (PO) repeat units. Alternatively, to minimize foaming and ensure strong suppression, the polyether may comprise a terminal exterior block comprising at least 5, more preferably at least 10, propylene oxide (PO) repeat units bonded to a relatively more interior block comprising at least 5, preferably at least 10 ethylene oxide (EO) repeat units.

Optionally, the PO/EO polyethers are capped by a substituted or unsubstituted alkyl group, aryl group, aralkyl, or heteroaryl group. A preferred capping moiety for its ease of manufacture and low cost is a methyl group.

The suppressor compounds comprising polyether groups covalently bonded to a nitrogen comprise a positive charge in acidic solution and repeat units, EO and PO. It is thought that the separate functionalities of the positive charge, the EO repeat units, and the PO repeat units contribute different chemical and physical properties which affect, and thereby enhance, the function of the polyether as a suppressor in the copper plating compositions of the present invention. Without being bound to a particular theory, it is thought that the positive charge of the cationic species enhances the attraction of the suppressor compound to copper deposited into interconnect features, which, during an electrolytic plating operation, functions as the cathode. It is believed that the PO repeat unit is the more active repeat unit in the suppressors of the present invention. That is, the PO repeat unit has suppressor functionality and affects the quality of the copper deposit. Without being bound to a particular theory, it is thought that the PO repeat units, being relatively hydrophobic form a polarizing film over a copper seed layer and electrolytically deposited copper.

A copper seed layer may be deposited over the barrier layer in interconnect features by CVD, PVD, or other methods known in the art. The copper seed layer acts as the cathode for further reduction of copper that superfills the interconnects during the electrolytic plating operation. Copper seed layers can be thin (i.e., less than about 3 nm, such as between 1 and 3 nm). However, the copper thickness on the bottom or sidewall of features is typically much thinner than those on the feature top and unpatterned areas due to the non-uniform deposition rates of PVD processes.

In some extreme circumstances, the copper coverage on the bottom or sidewall can be so thin that the seed layer is discontinuous. Thus, in some instances the substrate comprises surface portions which have a copper seed layer thereon which is less than about 700 angstroms thick, and in some instances the seed layer is discontinuous.

In another case, the seed layer coverage on the top of features is thicker than on other feature areas, which is often called "seed overhang." Generally, the uniformity of seed layer coverage degrades significantly with shrinking feature size and increasing aspect ratio. However, the inventors of the present invention have found that the present invention performs well, and better than the prior art, even with thin or overhanging seed layers.

The suppressor compound with somewhat hydrophobic PO repeat units covalently bonded to a nitrogen-containing cationic species is able to form a suppressive film over the copper seed layer. In the case of thin copper seed coverage, this polarizing organic film can cause the current to be more evenly distributed over the entire interconnect feature, i.e., the bottom and sidewalls of the via or trench. Even current distribution is believed to promote faster bottom up growth relative to sidewall growth, and may also reduce or eliminate bottom and sidewall voiding.

The strongly suppressive suppressor described herein is also desirable to suppress copper growth at the seed overhang areas on the top of the interconnect features, reducing the formation of internal voids from early pinching off.

The inventors of the present invention have discovered that the suppressor compound comprising a polyether group covalently bonded to a cationic species of the present invention is effective at suppressing copper deposition over thin or thick copper seed layers, and at enhancing nucleation density. In contrast, a polyether comprising of only PO repeat units, being relatively hydrophobic, lacks the solubility necessary to act as an adequate suppressor and lead to unacceptably high defectivity. That is, while PO is a superior suppressor, a polymer consisting of only of PO repeat units may not be soluble enough to go into the copper plating solution so that it can adsorb onto the copper seed layer in a high enough concentration to form a polarizing film. Accordingly, the polyether group preferably comprises EO repeat units to enhance its hydrophilicity and thus its solubility.

In those embodiments where the cationic species comprises a nitrogen atom, each nitrogen atom can be covalently bonded to one, two, or three PO/EO polyethers. Preferably, the nitrogen atom is covalently bonded to two PO/EO polyethers. In embodiments where the cationic species is a primary, secondary, or tertiary amine, the nitrogen atom can be alkylated to quaternize the nitrogen atom and render it positively charged. Preferably, the alkyl group is a short chain hydrocarbon radical having between 1 and 8 carbons, such as methyl, ethyl, n-propyl, isopropyl, and the like. Preferably the alkyl group is a methyl group. Accordingly, the nitrogen atom can form a quaternary amine having a positive charge where the suppressor comprises, for example, two PO/EO polyethers covalently bonded to a methylated alkylamine.

The suppressors comprised in the electrolytic deposition composition used in the electrolytic deposition process correspond to the structure: 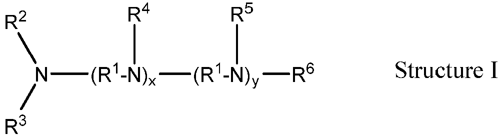 wherein x is an integer between 0 and 4, y is an integer between 0 and 4, x+y is an integer between 2 and 6, R¹ comprises an alkylene group, and at least one of R², R³, R⁴, R⁵ and R⁶ comprises a polyether substituent comprising a block copolymer of propylene oxide and ethylene oxide, wherein a linear portion of the polyether substituent comprises a block of EO repeat units bonded to a block of PO repeat units, and each of the remainder of R², R³, R⁴, R⁵ and R⁶ is selected from the group consisting of hydrogen, lower alkyl, aminoalkyl, hydroxyalkyl and a polyether substituent comprising propylene oxide (PO) repeat units, ethylene oxide (EO) repeat units, or a combination of PO and EO repeat units. The ratio of propylene oxide repeat units (PO) to ethylene oxide (EO) repeat units in the at least one polyether substituent, preferably in all polyether substituents and in the molecule as a whole, is generally between 2:8 and 7:3, more preferably between 4:6 and 6:4. In certain preferred embodiments, the PO/EO ratio is relatively low, i.e., between 3:7 and 6:5, or between 0.25:1 and 1.4:1, or between 0.25:1 and 1.1:1. Especially in species in which x+y of Structure I has a value of 3, optimally enhanced polarization can be realized at a PO/EO ratio between 1.1:1 and 1.4:1.

Preferably at least two of R², R³, R⁴, R⁵ and R⁶ comprise a polyether comprising a block copolymer of propylene oxide (PO) and ethylene (EO), more preferably at least three, and most preferably each of R², R³, R⁴, R⁵ and R6, comprises a PO/EO block copolymer. In each case, the PO/EO ratio is preferably between about 2:8 and about 7:3, more preferably between about 4:6 and about 6:4, or any of the other more finely tuned ratios described above.

The suppressor compounds described above is present in an overall bath concentration between 50 mg/L to 200 mg/L. Adding the weakly cationic polyether suppressors to Cu plating compositions within these concentration ranges is sufficient to fill complex features in an integrated circuit device, with the added benefits of reducing early pinching off, bottom voiding, or sidewall voiding.

Particularly preferred suppressors correspond to the following structure: 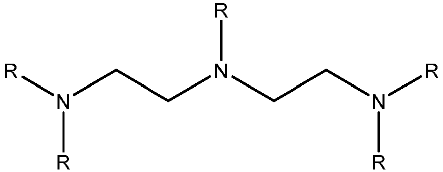 where 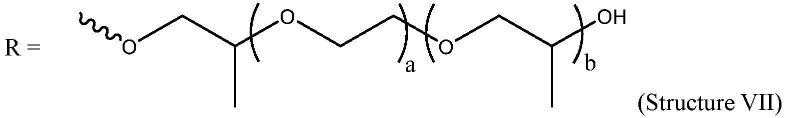 wherein a has an average value between 10 and 14, b has an average value between 12 and 16, the molar ratio of PO units to EO units is between 1:1 and 1.3:1 and the molecular weight is between 6,500 and 7,500; 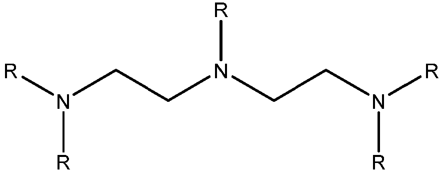 where 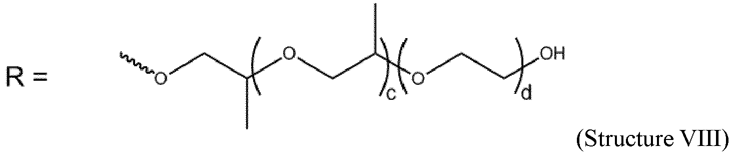 wherein c has an average value between 12 and 16, d has an average value between 10 and 14, the molar ratio of PO units to EO units is between 1:1 and 1.3:1 and the molecular weight is between 6,500 and 7,500; 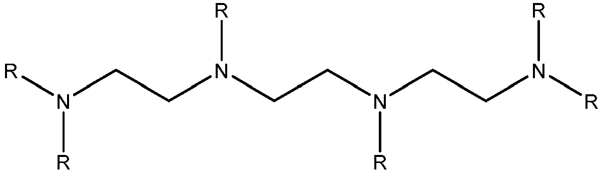 where 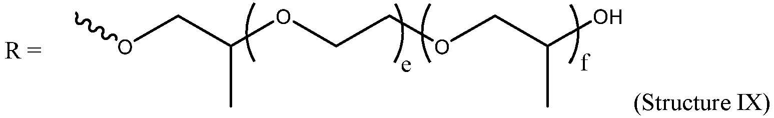 wherein e has an average value between 14 and 16, f has an average value between 6 and 9, the molar ratio of PO units to EO units is between 0.5:1 and 0.7:1, and the molecular weight is between 6,500 and 7,500; 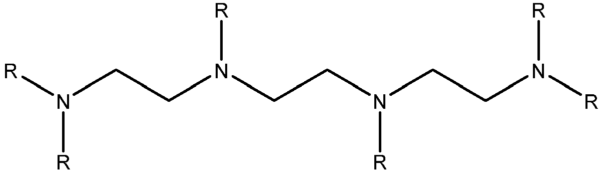 where 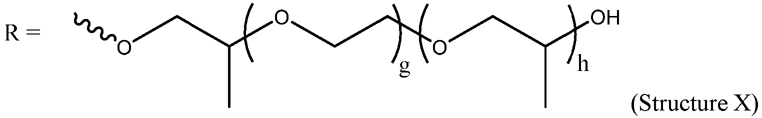 wherein g has an average value between 18 and 24, h has an average value between 9 and 12, the molar ratio of PO units to EO units is between 0.4:1 and 0.7:1, and the molecular weight is between 9,000 and 11.000; and 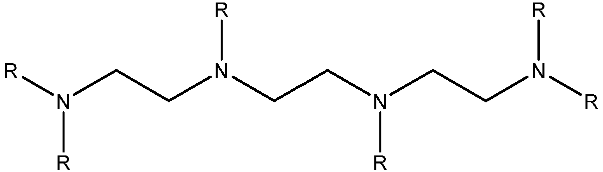 where: 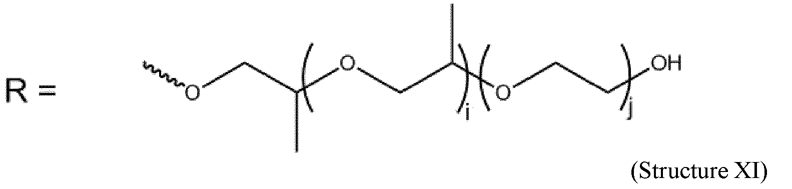 wherein i has an average value between 6 and 9, j has an average value between 14 and 16, the molar ratio of PO units to EO units is between 0.5:1 and 0.7:1 and the molecular weight is between 6,500 and 7,500.

Relatively void-free deposits have also been provided using suppressors corresponding to the structures: 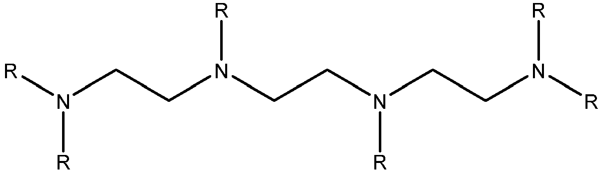 where 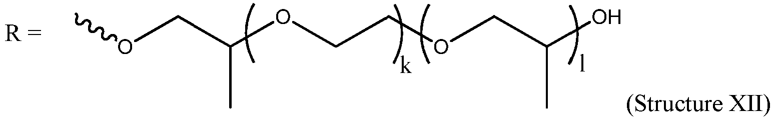 and k has an average value between 15 and 20, 1 has an average value between 3 and 7, the molar ratio of PO units to EO units is between 0.25:1 and 0.4:1 and the molecular weight is between 9,000 and 11,000; and 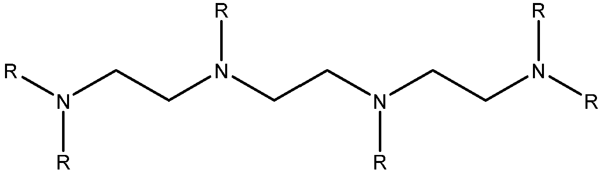 where: 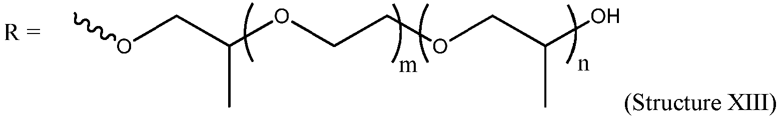 and m has an average value between 10 and 24, n has an average value between 8 and 12, the molar ratio of PO units to EO units is between 0.8:1 and 1.0:1 and the molecular weight is between 6,500 and 7,500.

Among the suppressors of Structure VII to XIII, particularly preferred suppressors correspond to structure 11 to 17, respectively: 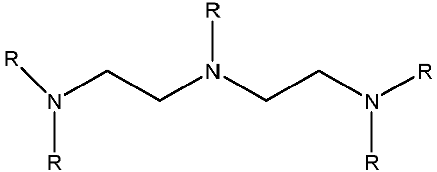 where 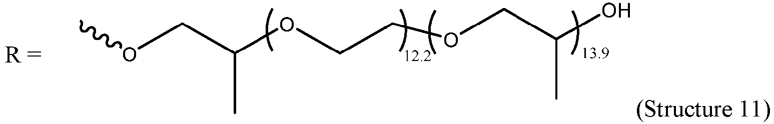 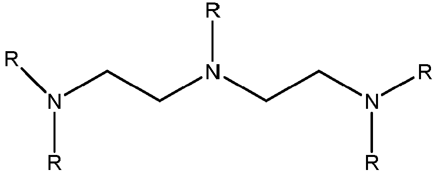 where 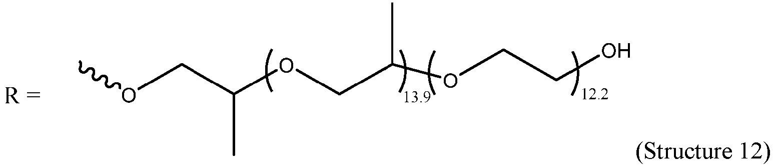 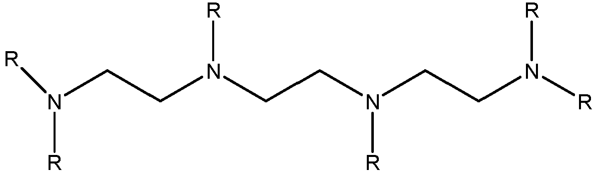 where 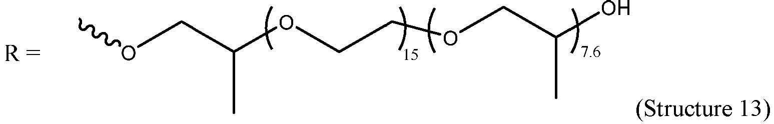 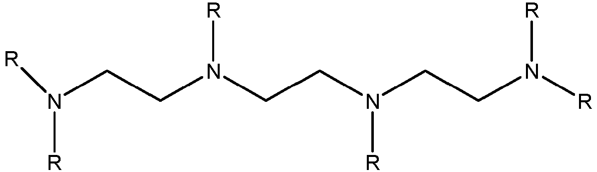 where 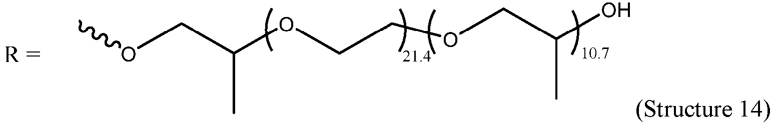 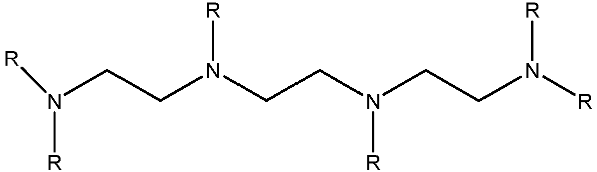 where 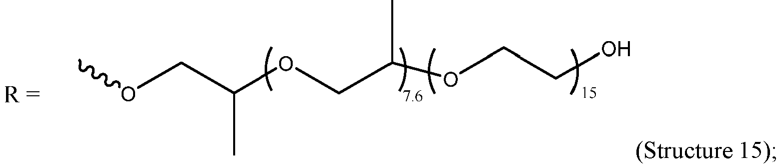 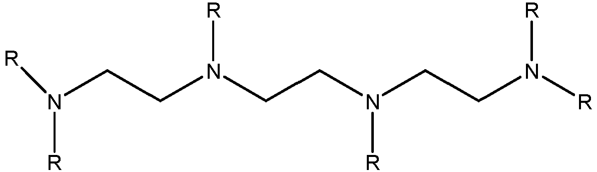 where 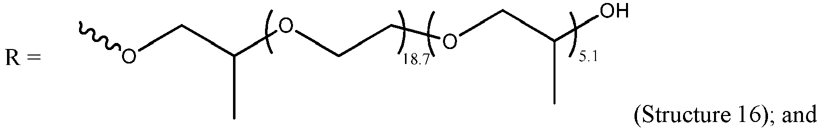 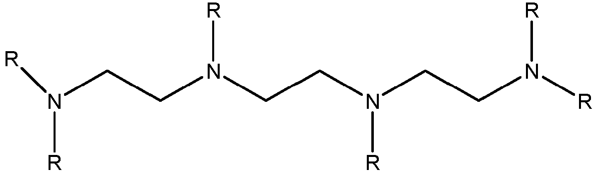 where

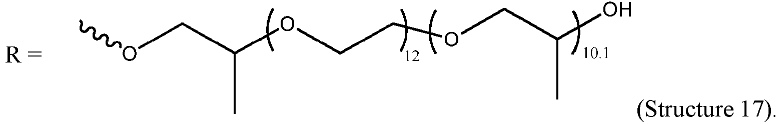

As noted above, alkoxylated amine groups of the suppressor by optionally be quaternized. To prepare the quaternized amine embodiments, the amines sites are first alkoxylated to provide polyether substituents having the PO/EO relationships and patterns as described above, after which the alkoxylated amine is react with a quaternizing agent such as an aliphatic or aromatic halide or sulfate to quaternize one or more of the amine sites. Generally amine sites separated only by a short alkylene group, e.g., where R¹ is ethylene or propylene, are not both quaternized in the reaction. Thus, e.g., where x+y =3 or x+y = 4, the quaternized suppressors may typically correspond to the structure: 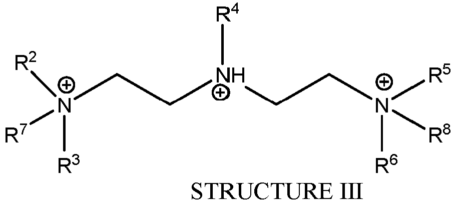 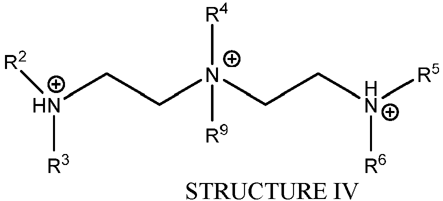 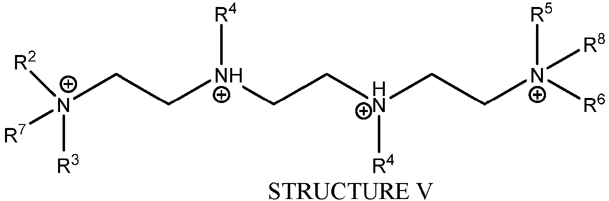 and 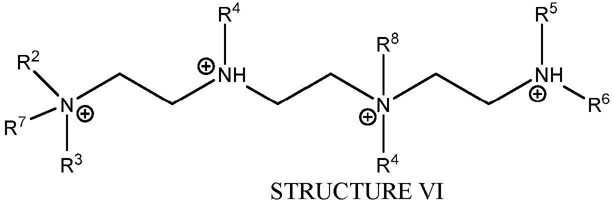 wherein at least one of R², R³, R⁴, R⁵ and R⁶ comprises a polyether substituent comprising a block copolymer of propylene oxide and ethylene oxide wherein the ratio of propylene oxide (PO) repeat units to ethylene oxide (PO) repeat units is between 0.25:1 and1.4:1, each of the remainder of R², R³, R⁴, R⁵ and R⁶ is selected from the group consisting of hydrogen, lower alkyl, aminoalkyl, hydroxyalkyl and a polyether substituent comprising propylene oxide (PO) repeat units, ethylene oxide (EO) repeat units, or a combination of PO and EO repeat units, each of R⁷ and R⁸ is selected from the group consisting of alkyl, aryl, aralkyl, alkenyl, and a proton, at least one of R⁷ and R⁸ is other than a proton, R⁹ is selected from the group consisting of alkyl, aryl, aralkyl, and alkenyl, and the number average molecular weight of the suppressor compound is between 6,000 and 12,000.

It has been discovered that electrolytic plating baths containing alkoxylated oligo(alkylene imine) suppressors in combination with accelerators as described elsewhere herein are capable of bottom-up superfilling of vias and trenches having an entry dimension less than 500 nm, or less than 200 nm, or less than 100 nm, or less than 50 nm. It has been found that use of the novel plating composition comprising the suppressor of Structure II is effective for superfilling of features having an entry dimension of less than 25 nm, or less than 20 nm, or less than 15 nm, or even less than 10 nm.

The compositions described herein also optionally, but preferably, include a leveler which can enhance leveling effect without substantially interfering with superfilling of copper into high aspect ratio features. Examples of suitable levelers can be found, for example in U.S. Pat. Pub. No. 2005/0045488 A1 to Paneccasio et al.. It has been found that this type of leveler does not substantially interfere with superfilling, so the copper bath can be formulated with a combination of accelerator and suppressor additives which provides a rate of growth in the vertical direction which is substantially greater than the rate of growth in the horizontal direction, and even more so than in conventional superfilling of larger interconnects. The leveler is incorporated, for example, in a concentration between about 0.01 mg/L and about 25 mg/L, more preferably about 0.1 to about 15 mg/L, more preferably about 1.0 to about 6.0 mg/L.

A particularly preferred leveler comprises a dipyridyl polymer. In various embodiments, the leveler corresponds to the structure: 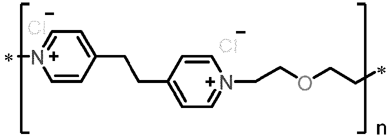 where n has a value between 3 and 15, preferably between 5 and 10, e.g. 9-10 (Leveler I) or 7-8 (Leveler II). In other embodiments, the leveler comprises the reaction product of a dipyridyl compound and a diglycidyl ether, for example the reaction product of: 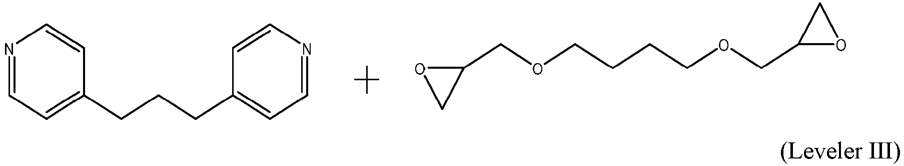 as prepared, e.g., in an aqueous medium at 90 °C over a reaction period of 3 hours.

In further and alternative embodiments, the leveler comprises the reaction product of: 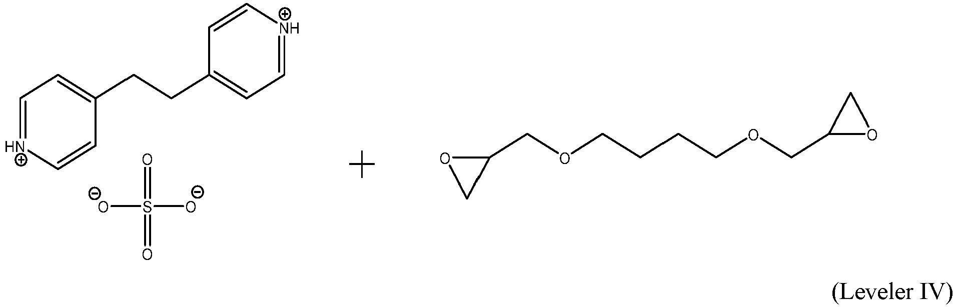 wherein the reaction is conducted in an aqueous medium passing through a flow reactor at a temperature of 160 °C under 9.3 bar pressure and a residence time of two minutes. Those skilled in the art will understand that the sulfate salt is illustrative, and that the diglycidyl ether can be reacted with a dipyridyl salt of any compatible anion, e.g., chloride or bromide, to yield the dipyridyl polymer leveler. According to a still further alternative, the leveler may comprise the reaction product of a dipyridyl compound and a diglycidyl ether of a polyalkylene oxide or oligoalkylene oxide such as, e.g.: 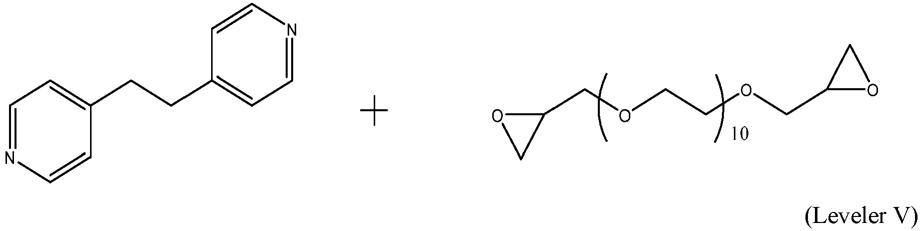 which may be prepared, e.g., by reaction in an ethylene glycol medium passing through a flow reactor at a temperature of 160 °C and 9.3 bar pressure.

With regard to accelerators, the accelerators may be bath soluble organic divalent sulfur compounds as described, for example in U.S. Pat. 6,776,893 B1 to Too et al..

In one preferred embodiment, the accelerator corresponds to the formula (10):

R₁-(S)ₙRXO₃M (10),

wherein
M is hydrogen, alkali metal or ammonium as needed to satisfy the valence;
X is S or P;
R is an alkylene or cyclic alkylene group of 1 to 8 carbon atoms, an aromatic hydrocarbon or an aliphatic aromatic hydrocarbon of 6 to 12 carbon atoms;
n is 1 to 6; and
R₁ is MO₃XR wherein M, X and R are as defined above.

In another preferred embodiment, the accelerator is 1-propanesulfonic acid, 3,3'-dithiobis, disodium salt according to the following formula (11):

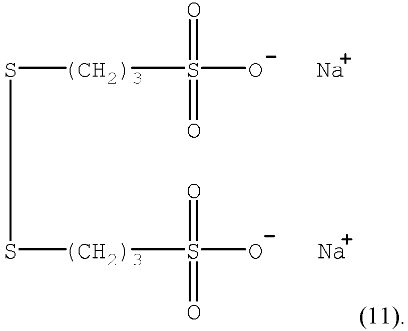

The accelerator is incorporated typically in a concentration between about 0.5 and about 1000 mg/L, more typically between about 2 and about 100 mg/L, such as between about 50 and 90 mg/L.

The inventors of the present invention have found that the electrolytic compositions described herein and containing the described suppressors permit the use of a greater concentration of accelerator, and, in many applications, it must be used in combination with a higher concentration of accelerator than in conventional processes. This allows for enhanced rates of superfilling, as described, for example, in Example 7 below.

Optionally, additional leveling compounds can be incorporated into the bath, including, for example a reaction product of benzyl chloride and hydroxyethyl polyethylenimine as disclosed in U.S. Pat. Pub. No. 2003/0168343 A1 to Commander et al..

The accelerator, suppressor and leveler compositions described herein can be used in various combinations and at various concentrations to obtain the desired result of low defects, including the prevalence of very few to no voids. Thus, it is desirable that the combination of accelerator(s), suppressor(s) and leveler(s) in the bath produce a deposit that has substantially no voids, meaning that the deposit contains less than 75 voids per 5 µm², more preferably less than 50 voids per µm² and even more preferably less than 10 voids µm².

The concentration and type of accelerator, suppressor and leveler can be optimized to produce the desired result.

The components of the copper electrolytic plating bath may vary widely depending on the substrate to be plated and the type of copper deposit desired. The electrolytic baths described herein include acid baths and alkaline baths. A variety of copper electrolytic plating baths are described in the book entitled Modern Electroplating, edited by F. A. Lowenheim, John Reily & Sons, Inc., pages 183-203 (1974). Exemplary copper electrolytic plating baths include copper fluoroborate, copper pyrophosphate, copper cyanide, copper phosphonate, and other copper metal complexes such as methane sulfonic acid. The most typical copper electrolytic plating bath comprises copper sulfate in an acid solution.

The concentration of copper and acid may vary widely, for example, from about 2 to about 70 g/L copper and from about 2 to about 225 g/L acid. In this regard the suppressors of Structure I are suitable for use in all acid/ copper concentration ranges, such as high acid/low copper systems, in low acid/high copper systems, and mid acid/high copper systems.

In high acid/low copper systems, the copper ion concentration can be on the order of 4 g/L to on the order of 30 g/L; and the acid concentration may be sulfuric acid in an amount of greater than about 100 g/L up to about 225 g/L. In one high acid/low copper system, the copper ion concentration is about 17 g/L and the H₂SO₄ concentration is about 180 g/L.

In low acid/high copper systems, the copper ion concentration can be on the order of greater than about 30 g/L, greater than about 40 g/L, and even up to on the order of about 60 g/L copper (it is noted that 50 g/L copper corresponds to 200 g/L CuSO₄·5H₂O copper sulfate pentahydrate). The acid concentration in these systems is less than about 50 g/L, less than about 40 g/L, and may even be less than about 30 g/L H₂SO₄, down to about 2 g/L. In one exemplary low acid/high copper system, the copper concentration is about 40 g/L and the H₂SO₄ concentration is about 10 g/L.

In mid acid/high copper systems, the copper ion concentration can be on the order of 30 g/L to on the order of 60 g/L, and the acid concentration may be sulfuric acid in an amount of greater than about 50 g/L up to about 100 g/L. In one mid acid/high copper system, the copper ion concentration is about 50 g/L and the H₂SO₄ concentration is about 80 g/L.

Chloride ions may also be used in the bath at a level up to 200 mg/L, preferably up to 100 mg/L, more preferably about 10 to 90 mg/L. Chloride ions are added in these concentration ranges to enhance the function of other bath additives, including accelerators, suppressors, and levelers. One preferred low copper/low acid electrodeposition bath contains about 5 g/L copper ion, about 10 g/L sulfuric acid and about 50 ppm chloride ion.

A large variety of additives may typically be used in the bath to provide desired surface finishes for the copper plated metal. Usually more than one additive is used with each additive forming a desired function. At least two additives are generally used to initiate bottom-up filling of interconnect features as well as for improved metal plated physical (such as brightness), structural, and electrical properties (such as electrical conductivity and reliability). Particular additives (usually organic additives) are used for grain refinement, suppression of dendritic growth, and improved covering and throwing power. Various additives used in electrolytic plating are discussed in a number of references including Modern Electroplating, cited above. A particularly desirable additive system uses a mixture of aromatic or aliphatic quaternary amines, polysulfide compounds, and polyethers. Other additives include ingredients such as selenium, tellurium, and sulfur compounds.

Plating equipment for plating semiconductor substrates are well known in the art as described, for example, in U.S. Pat. 6,024,856 to Haydu et al.. Plating equipment typically comprises an electrolytic plating tank which holds the copper electrolytic solution and which is made of a suitable material such as plastic or other material inert to the electrolytic plating solution. The tank may be cylindrical, especially for wafer plating. A cathode is horizontally disposed at the upper part of tank and the cathode may be any type of substrate such as a silicon wafer having openings such as trenches and vias. The wafer substrate is typically coated first with a barrier layer, which may be titanium nitride, tantalum, tantalum nitride, or ruthenium to inhibit copper diffusion and then with a seminal conductive layer, typically a seed layer of copper or other metal substrate for initiation of copper superfilling. A copper seed layer may be applied, for example, by chemical vapor deposition (CVD), physical vapor deposition (PVD), or the like. The anode may also be circular (i.e., for wafer plating) and be horizontally disposed at the lower part of tank forming a space between the anode and cathode. In one embodiment, the anode is a soluble anode including, for example, copper metal.

The electrolytic compositions comprising the bath additives described herein are also useful in combination with membrane technology. Thus, in one preferred embodiment, the anode may be isolated from the organic bath additives by a membrane in order to minimize the oxidation of the organic bath additives on the anode surface.

The cathode substrate and anode are electrically connected by wiring and, respectively, to a rectifier (power supply). The cathode substrate for direct or pulse current has a net negative charge so that copper ions in the solution are reduced at the cathode substrate forming plated copper metal on the cathode surface. An oxidation reaction takes place at the anode. The cathode and anode may be disposed horizontally or vertically in the tank.

Current is supplied from a power source having its negative terminal in electrical communication with the seminal conductive layer, typically a copper seed layer, in the submicron features. The positive terminal of the power source is in electrical communication with an anode in contact with said electrolytic solution.

During operation of the electrolytic plating system of the invention, copper metal is plated on the surface of a cathode substrate when the rectifier is energized. A pulse current, direct current, reverse periodic current, or other suitable current configuration may be employed. The temperature of the electrolytic solution may be maintained using a heater/cooler whereby electrolytic solution is removed from the holding tank and flows through the heater/cooler and then is recycled to the holding tank.

In the case of thin copper seed coverage, less current will be delivered to the lower portions of interconnect features, which may lead to bottom or sidewall voids and slow bottom-up growth. For features which have seed overhang, the electrolytic copper growth may have early pinching off on the feature tops before the bottom-up growth can reach the surface. Conventional suppressors may not distribute enough current to the bottom of the interconnect feature to promote bottom-up superfilling rapid enough to prevent the pinching off of interconnect features by copper electrolytic deposition leading to the formation of internal voids, especially for features seeded with a thin copper seed layer. Also, conventional suppressors may not have strong enough suppression to suppress copper growth on seed overhang areas to prevent early pinching off.

Without being bound to a particular theory, it is thought that the suppressor compounds of the present invention function to inhibit the formation of internal voids and enhance the bottom-up superfilling deposition rate by up to twice the rate over a typical electrolytic plating solution not comprising the suppressor compounds of the present invention by forming a polarizing film over the copper seed layer. Also, the suppressor compounds described herein possess stronger suppression (more polarizing) than most conventional suppressors, which allows the current to be distributed more evenly over the copper seed layer deposited on the bottom and sidewalls of the interconnect feature leading to the reduction or elimination of bottom and sidewall voids. An even current distribution enhances copper growth at the bottom of the feature relative to deposition at other regions to such an extent that bottom-up superfilling occurs so rapidly that deposition at the side and top of the feature will not cause a pinching off of the deposit and the formation of internal voids. The suppressor compounds of the present invention are effective at rapid bottom-up superfilling over thin or overhanged copper seed layers. For example, the suppressor compounds have been found effective to superfill an interconnect feature seeded with a thin copper seed layer on the bottom and side walls of an interconnect feature having a thickness between about 1 Angstrom and about 100 Angstroms.

An advantage of adding the suppressor compounds of the present invention to electrolytic copper plating solutions in the manner described herein is the reduction in the occurrence of internal voids as compared to deposits formed from a bath not containing these compounds. Internal voids form from copper depositing on the feature side walls and top entry of the feature, which causes pinching off and thereby closes access to the depths of the feature. This defect is observed especially with features which are small (e.g., less than about 100 nm) and/or which have a high aspect ratio (depth:width), for example, greater than about 4:1. Those voids left in the feature can interfere with electrical connectivity of copper interconnects. The suppressor compounds described herein appear to reduce the incidence of internal voids by the above-described rapid superfilling mechanism and strong suppression.

Optionally, the plating system of the invention may be controlled as described in U.S. Pat. 6,024,856 to Haydu et al., by removing a portion of the electrolytic solution from the system when a predetermined operating parameter (condition) is met. Thereafter, new electrolytic solution is added to the system either simultaneously or after the removal in substantially the same amount. The new electrolytic solution is preferably a single liquid containing all the materials needed to maintain the electrolytic plating bath and system. The addition/removal system maintains a steady-state constant plating system having enhanced plating effects such as constant plating properties. With this system and method the plating bath reaches a steady state where bath components are substantially a steady-state value.

Electrolysis conditions, including, for example, electric current concentration, applied voltage, electric current density, and electrolytic solution temperature, are essentially the same as those in conventional electrolytic copper plating methods. For example, the bath temperature may be maintained at about room temperature such as about 20-27 °C, but may be at elevated temperatures up to about 40 °C or higher. The electrical current density is typically up to about 100 mA/cm², typically about 2 mA/cm² to about 60 mA/cm². It is preferred to use an anode to cathode ratio of about 1:1, but this may also vary widely from about 1:4 to 4:1. The process also uses mixing in the electrolytic plating tank which may be supplied by agitation or preferably by the circulating flow of recycle electrolytic solution through the tank. The flow through the electrolytic plating tank provides a typical residence time of electrolytic solution in the tank of less than about 1 minute, more typically less than 30 seconds, e.g., 10-20 seconds.

In a particular preferred electrodeposition schedule for filling features having an entry dimension less than 50 nm, the current density is maintained at at least 3.5 mA/cm², more preferably at least 5 mA/cm². The current can be ramped up during the electrodeposition cycle. For example, electrodeposition can be initiated at a current density of at least 5 mA/cm² for 3 to 8 seconds, subsequently maintained at at least 7 mA/cm² for a second period of 10 to 30 seconds, and thereafter maintained at at least 15 mA/cm² for a period of at least 50 seconds. In one alternative, the current density is maintained at from 3 to 10 mA/cm² for a first period and from 8 to 20 mA/cm² for a second period in which the electrodeposition is concluded.

The following examples further illustrate the practice of the present invention.

### EXAMPLES

An electrodeposition makeup solution was prepared comprising copper sulfate (5 g/L Cu⁺⁺ ions), sulfuric acid (10 g/L), and chloride ion (50 mg/L). A dipyridyl polymer leveler corresponding to the structure: 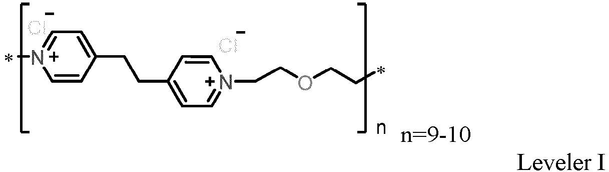 was added to the makeup solution in a concentration of 1.4 mg/L.

From the makeup solution comprising the dipyridyl polymer leveler, a series of experimental electrodeposition baths were prepared by adding an SPS accelerator at concentrations of 61 mg/L or 82 mg/L, and either of four separate suppressors at concentrations of either 100 mg/L or 200 mg/L.

Suppressor 13 had a number average molecular weight of 7,100 and comprised triethylene tetramine substituted at each amine site with a block copolymer of propylene oxide (PO) and ethylene oxide (EO) repeating units in a PO:EO molar ratio of 0.57: 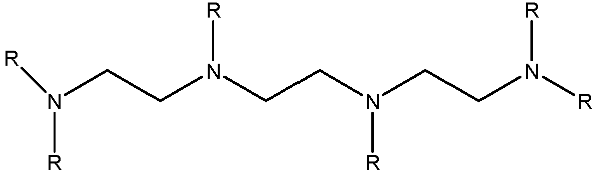 where

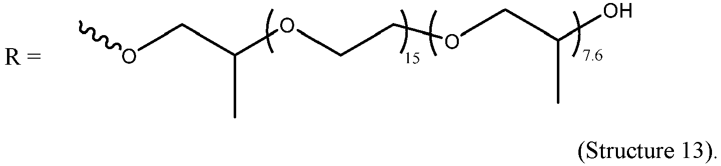

Suppressor 17 also had a molecular weight of 7,100 and comprised triethylene tetramine substituted at each amine site with a block copolymer of propylene oxide (PO) and ethylene oxide (EO) in a PO:EO molar ratio of 0.93. 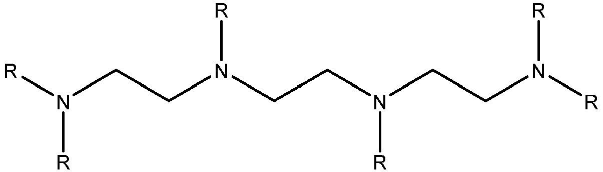 where

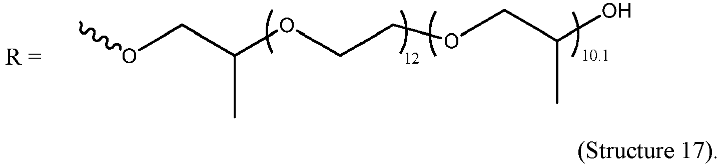

Suppressor 14 had a number average molecular weight of 9,970 and comprised triethylene tetramine substituted at each amine site with a block copolymer of propylene oxide (PO) and ethylene oxide (EO)in a PO:EO molar ratio of 0.57. 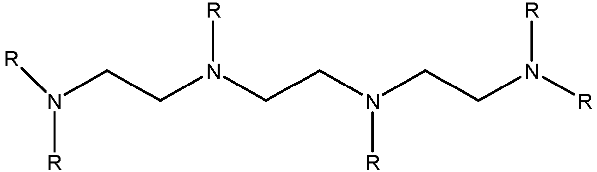 where

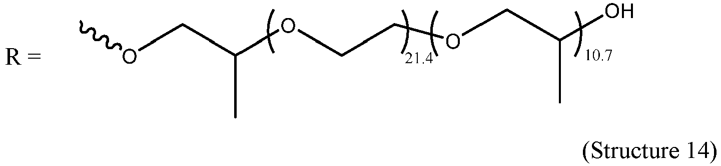

Suppressor 18 (not according to the present invention) had a number average molecular weight of 14,944 and comprised triethylene tetramine substituted at each amine site with a block copolymer of propylene oxide (PO) and ethylene oxide (EO) in a PO:EO molar ratio of 0.51:1 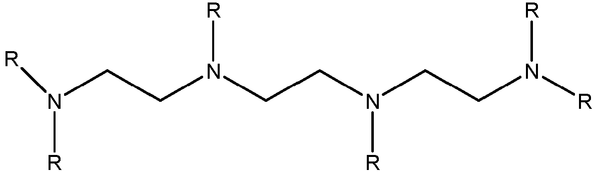 where

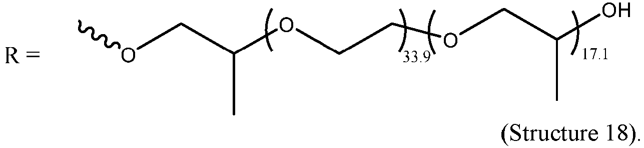

Suppressor 16 had a number average molecular weight of 7,100 and comprised triethylene tetramine substituted at each amine site with a block copolymer of propylene oxide (PO) and ethylene oxide (EO)in a PO:EO molar ratio of 0.32. 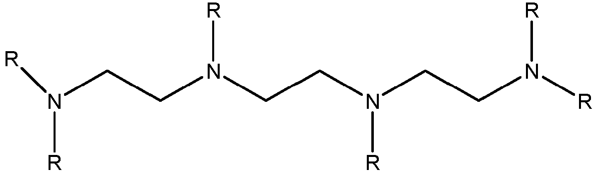 where

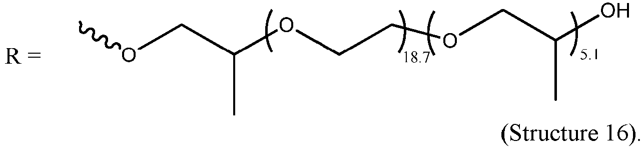

Using these plating solutions, twenty five separate electrodeposition runs were conducted in which submicron cavities in commercially available silicon wafers were superfilled. Each of the wafers comprised an isolated via chain region and a more dense via chain region, and the cavities had entry dimensions of 8 to 14 nm and an aspect ratio of 10:1 to 15:1. Ten of the runs were conducted at high initial current density (2.8 mA/cm² for 4.5 seconds, followed by 10 mA/cm² for 22 seconds, and 20 mA/cm² for 78 seconds) while the remaining fifteen runs were conducted at low initial current density (1.6 mA/cm² for 6 seconds, followed by 10 mA/cm² for 20 seconds, and 20 mA/cm² for 78 seconds).

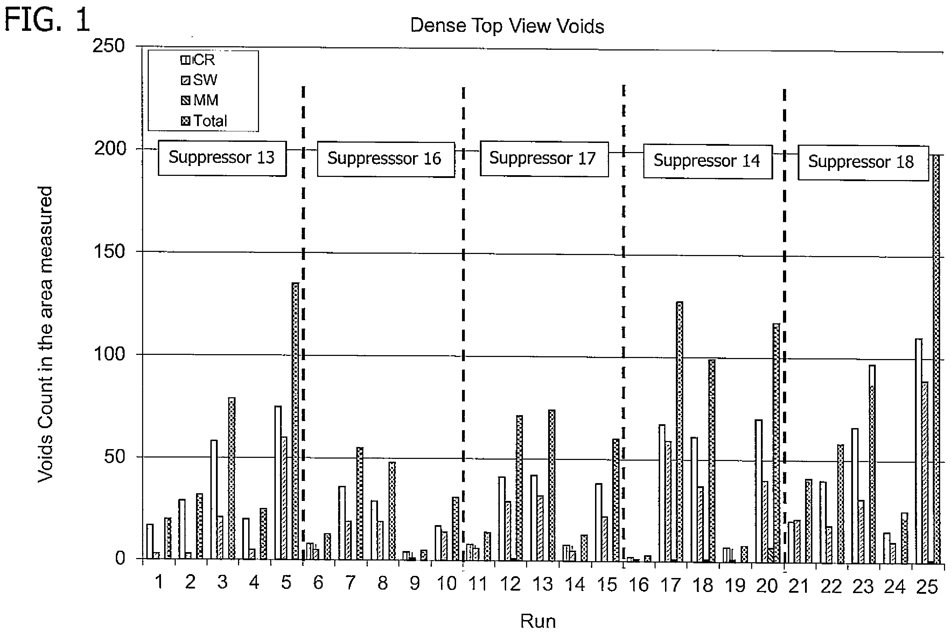

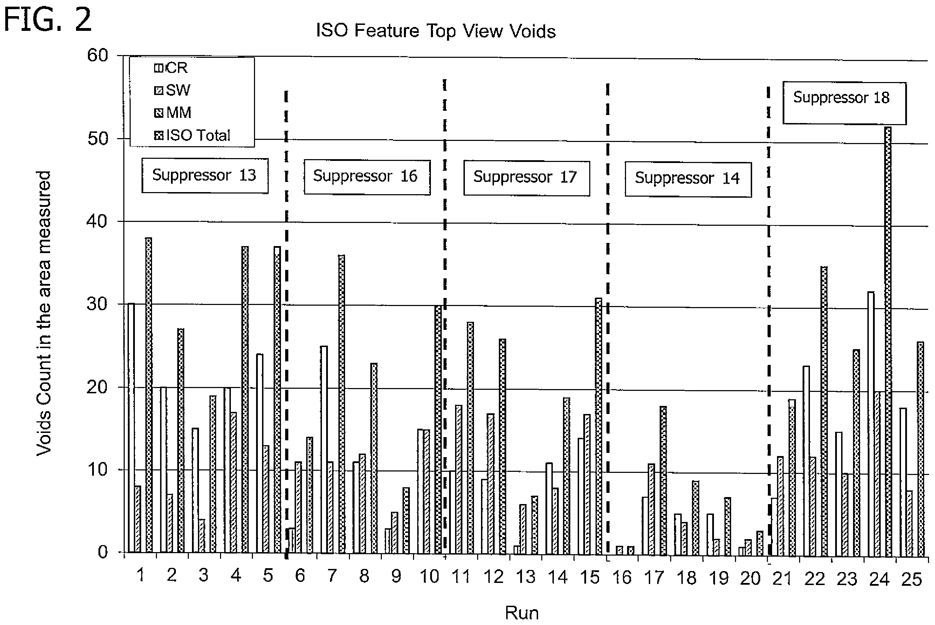

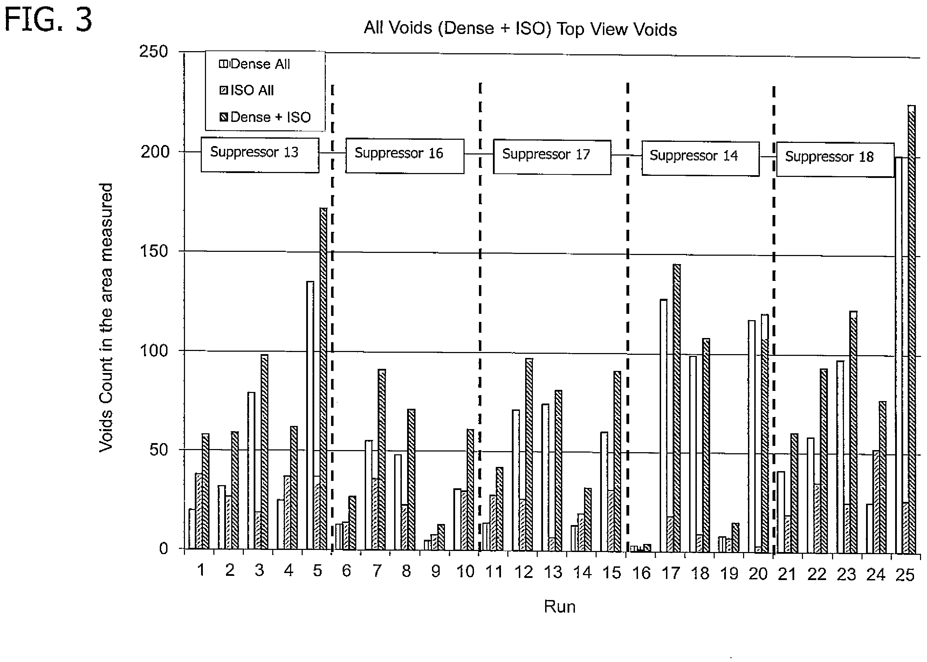

Observations were made of the prevalence of center voids, sidewall voids, and missing metal in the deposits formed in each of the runs. Prevalence of voids was determined from top view inspections of both the isolated via chain region (ISO) and the more dense via chain region of the wafer. Compositions of the electrodeposition baths, current densities, and observation of voids are set forth in Table 1. Runs 21-25 using suppressor 18 are not according to the invention. Void counts for the dense region are graphically illustrated in Fig. 1, void counts for the ISO region are graphically illustrated in Fig. 2 and the sum of dense and ISO void counts are illustrated in Fig. 3.

**Table 1**

| **ECD Conditions** | | | | | **Dense Top View Voids** | | | | **ISO Top View Voids** | | | | **Dense+ISO** |
|---|---|---|---|---|---|---|---|---|---|---|---|---|---|
| Run | SPS Accelerator * | Suppressor * | Leveler II * | Current Density | CR | SW | MM | Dense All | CR | SW | MM | ISO All | Dense+ISO |
| 1 | 61 mg/L | 13 (100 mg/L) | 1.4 mg/L | high | 17 | 3 | 0 | 20 | 30 | 8 | 0 | 38 | 58 |
| 2 | 61 mg/L | 13 (200 mg/L) | 1.4 mg/L | low | 29 | 3 | 0 | 32 | 20 | 7 | 0 | 27 | 59 |
| 3 | 82 mg/L | 13 (100 mg/L) | 1.4 mg/L | low | 58 | 21 | 0 | 79 | 15 | 4 | 0 | 19 | 98 |
| 4 | 82 mg/L | 13 (200 mg/L) | 1.4 mg/L | high | 20 | 5 | 0 | 25 | 20 | 17 | 0 | 37 | 62 |
| 5 | 82 mg/L | 13 (200 mg/L) | 1.4 mg/L | low | 75 | 60 | 0 | 135 | 24 | 13 | 0 | 37 | 172 |
| 6 | 61 mg/L | 16 (100 mg/L) | 1.4 mg/L | high | 8 | 5 | 0 | 13 | 3 | 11 | 0 | 14 | 27 |
| 7 | 61 mg/L | 16 (200 mg/L) | 1.4 mg/L | low | 36 | 19 | 0 | 55 | 25 | 11 | 0 | 36 | 91 |
| 8 | 82 mg/L | 16 (100 mg/L) | 1.4 mg/L | low | 29 | 19 | 0 | 48 | 11 | 12 | 0 | 23 | 71 |
| 9 | 82 mg/L | 16 (200 mg/L) | 1.4 mg/L | high | 4 | 1 | 0 | 5 | 3 | 5 | 0 | 8 | 13 |
| 10 | 82 mg/L | 16 (200 mg/L) | 1.4 mg/L | low | 17 | 14 | 0 | 31 | 15 | 15 | 0 | 30 | 61 |
| 11 | 61 mg/L | 17 (100 mg/L) | 1.4 mg/L | high | 8 | 6 | 0 | 14 | 10 | 18 | 0 | 28 | 42 |
| 12 | 61 mg/L | 17 (200 mg/L) | 1.4 mg/L | low | 41 | 29 | 1 | 71 | 9 | 17 | 0 | 26 | 97 |
| 13 | 82 mg/L | 17 (100 mg/L) | 1.4 mg/L | low | 42 | 32 | 0 | 74 | 1 | 6 | 0 | 7 | 81 |
| 14 | 82 mg/L | 17 (200 mg/L) | 1.4 mg/L | high | 8 | 5 | 0 | 13 | 11 | 8 | 0 | 19 | 32 |
| 15 | 82 mg/L | 17 (200 mg/L) | 1.4 mg/L | low | 38 | 22 | 0 | 60 | 14 | 17 | 0 | 31 | 91 |
| 16 | 61 mg/L | 14 (100 mg/L) | 1.4 mg/L | high | 2 | 1 | 0 | 3 | 0 | 1 | 0 | 1 | 4 |
| 17 | 61 mg/L | 14 (200 mg/L) | 1.4 mg/L | low | 67 | 59 | 1 | 127 | 7 | 11 | 0 | 18 | 145 |
| 18 | 82 mg/L | 14 (100 mg/L) | 1.4 mg/L | low | 61 | 37 | 1 | 99 | 5 | 4 | 0 | 9 | 108 |
| 19 | 82 mg/L | 14 (200 mg/L) | 1.4 mg/L | high | 7 | 1 | 0 | 8 | 5 | 2 | 0 | 7 | 15 |
| 20 | 82 mg/L | 14 (200 mg/L) | 1.4 mg/L | low | 70 | 40 | 7 | 117 | 1 | 2 | 0 | 3 | 120 |
| 21 | 61 mg/L | 18 (100 mg/L) | 1.4 mg/L | high | 20 | 21 | 0 | 41 | 7 | 12 | 0 | 19 | 60 |
| 22 | 61 mg/L | 18 (200 mg/L) | 1.4 mg/L | low | 40 | 18 | 0 | 58 | 23 | 12 | 0 | 35 | 93 |
| 23 | 82 mg/L | 18 (100 mg/L) | 1.4 mg/L | low | 66 | 31 | 0 | 97 | 15 | 10 | 0 | 25 | 122 |
| 24 | 82 mg/L | 18 (200 mg/L) | 1.4 mg/L | high | 15 | 10 | 0 | 25 | 32 | 20 | 0 | 52 | 77 |
| 25 | 82 mg/L | 18 (200 mg/L) | 1.4 mg/L | low | 110 | 89 | 1 | 200 | 18 | 8 | 0 | 26 | 226 |

| | | | | | | | | | | | | | |
|---|---|---|---|---|---|---|---|---|---|---|---|---|---|
| ISO = isolated via chain region Dense = more dense via chain region CR = center voids SW = side wall voids MM = missing metal | | | | | | | | | | | | | |

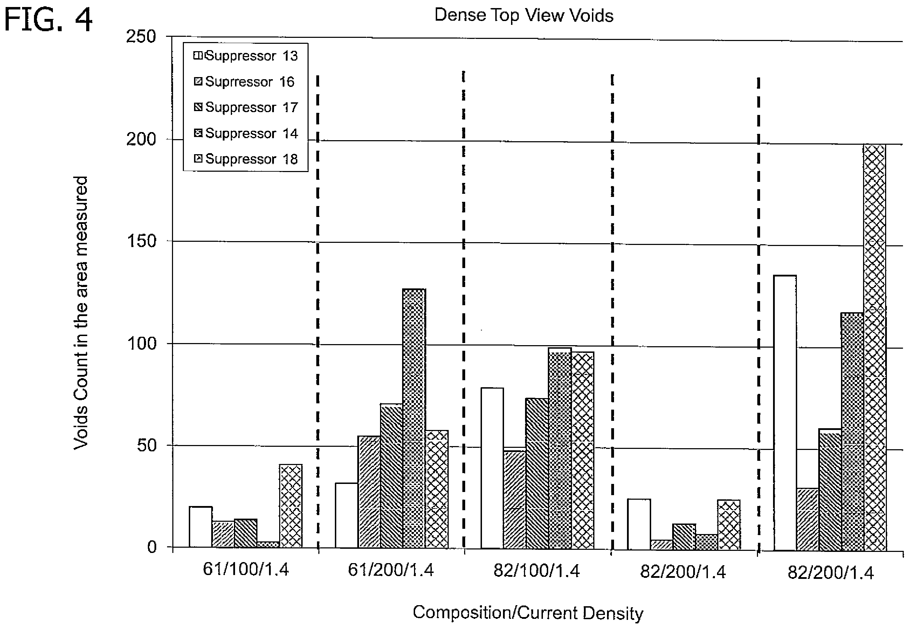

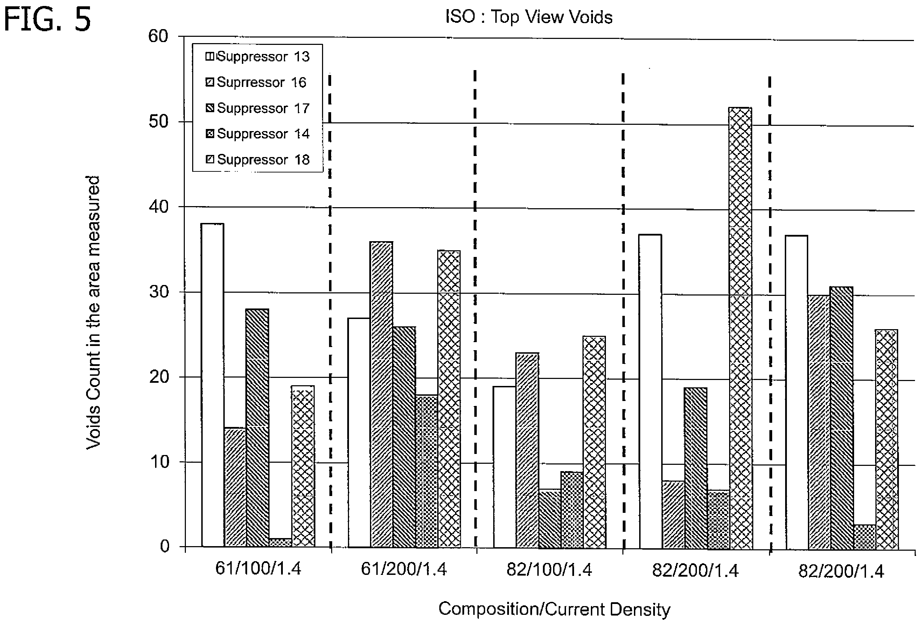

Figs. 4 and 5 depict the average results in the dense and ISO regions, respectively, for all runs of this Example at the indicated combinations of composition and conditions.

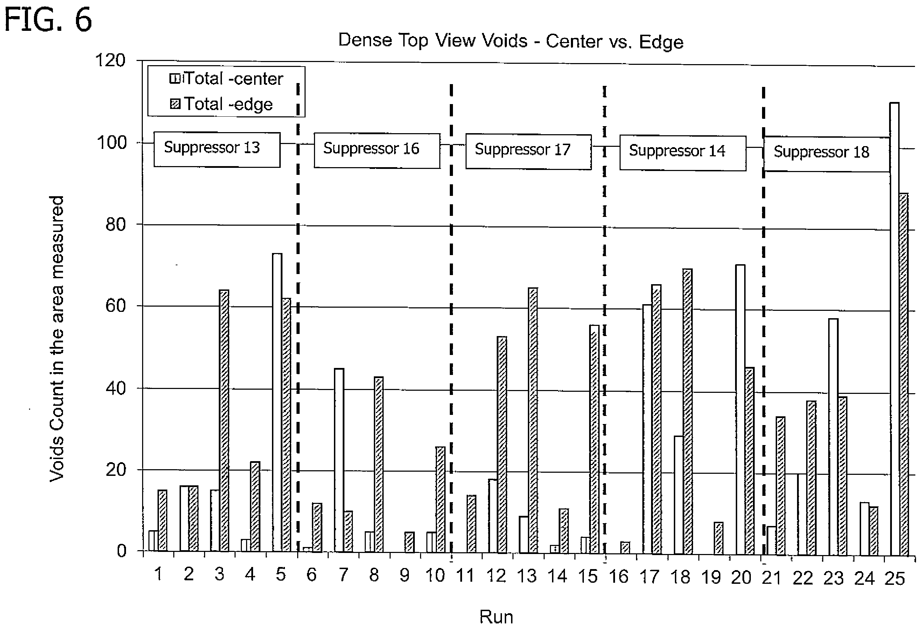

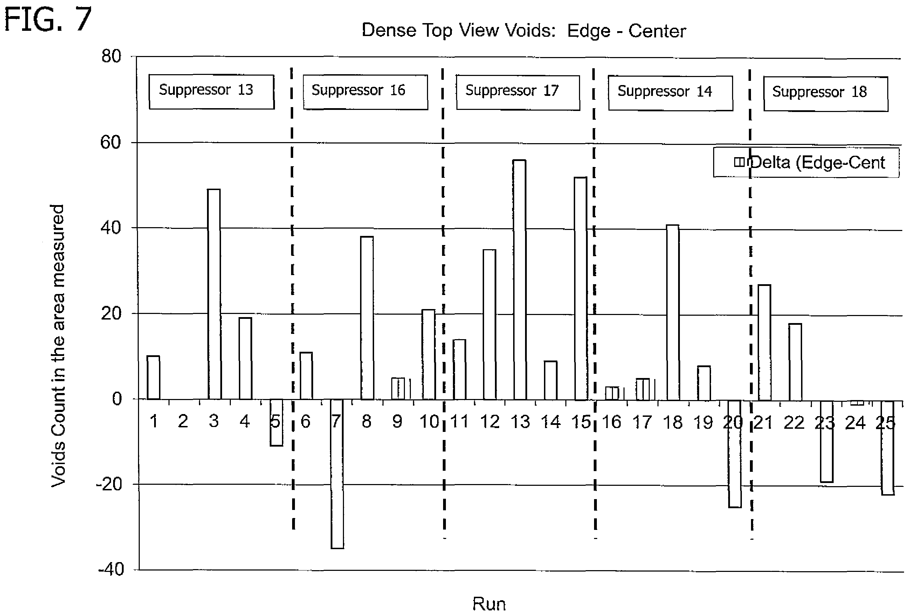

Fig. 6 graphically illustrates the prevalence of voids in the center vs. the edge of the dense region for the runs of this Example, and Fig. 7 illustrates the difference between edge and center voids.

The data reported in Table 1 and illustrated in Figs. 1 to 7, especially Figs. 4 and 5, reflect the combined effect of suppressor selection, suppressor concentration and accelerator concentration at constant leveler concentration of 1.4 mg/L.

### Example 2

From the makeup solution described in Example 1, a series of electrodeposition baths were prepared by adding suppressor 13 in a concentration of 200 mg/L, an SPS accelerator in a concentration of 82 mg/L, and varying proportions of either of five separate levelers. Structures of the levelers and the conditions under which levelers III, IV and V were synthesized are set out below:

| | |
|---|---|
| **Leveler** I | 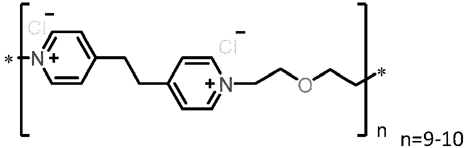 |
| **Leveler II** | 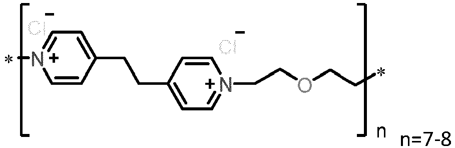 |
| **Leveler III** | 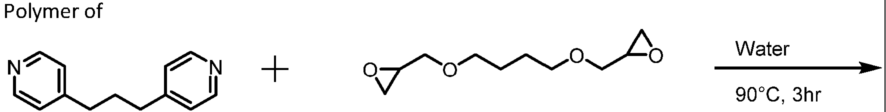 |
| **Leveler IV** | 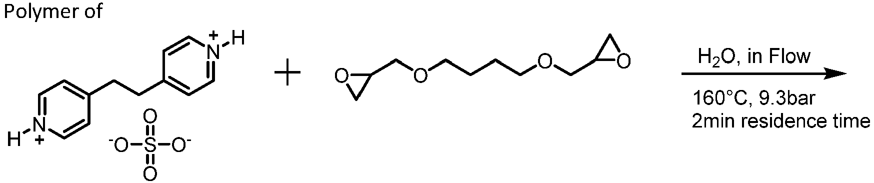 |
| **Leveler V** | 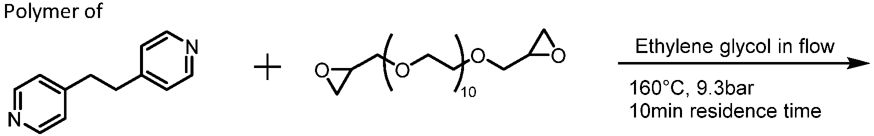 |

Eleven separate electrodeposition runs were made superfilling submicron cavities in commercially available silicon wafers, each wafer comprising an isolated via chain region (ISO) and a more dense via chain region. The cavities had an entry dimension of 8 to 14 nm and an aspect ratio of 10:1 to 15:1.

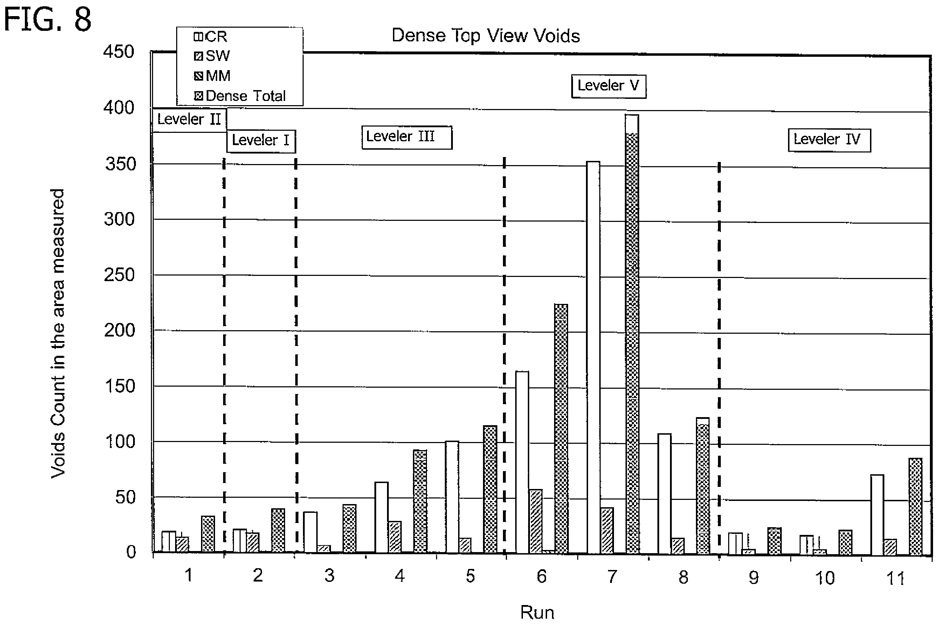

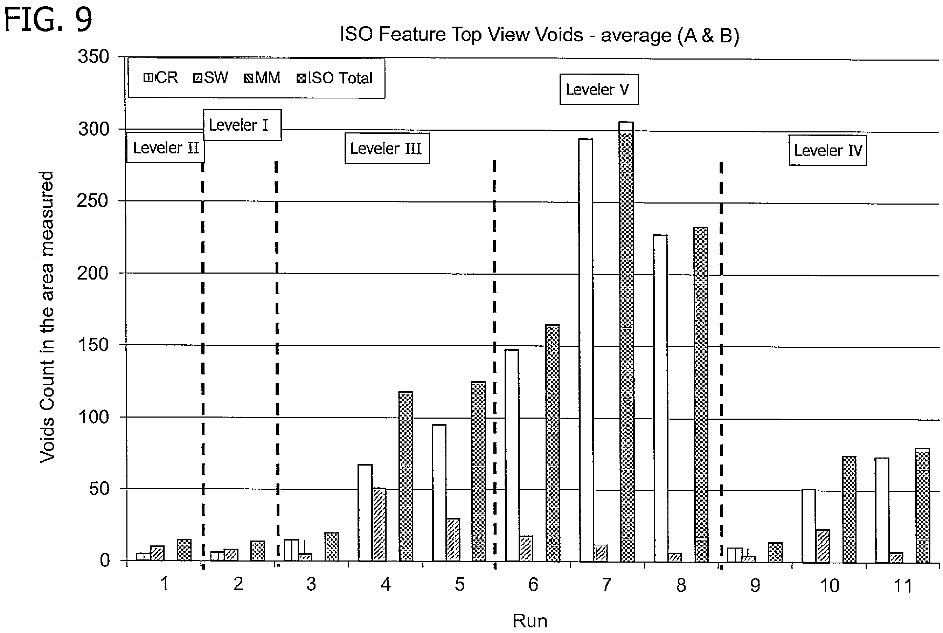

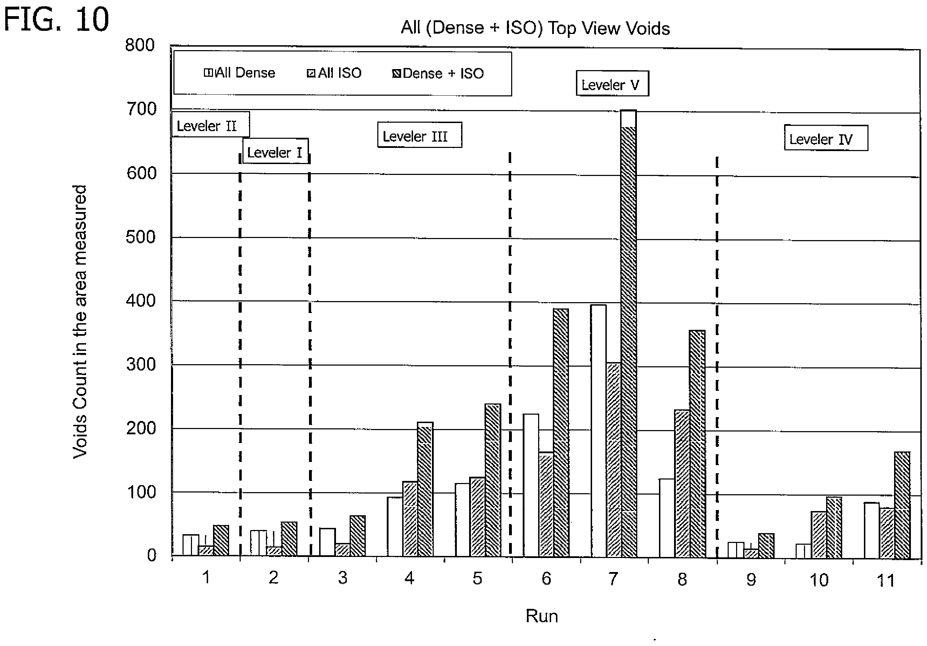

Observations were made of the prevalence of center voids, sidewall voids, and missing metal in the copper deposits formed from each combination of accelerator concentration, suppressor concentration, leveler selection, and leveler concentration. Prevalence of voids was again determined by top view inspections of both the isolated via chain regions (ISO) and the more dense via chain regions of the wafers. Compositions of the electrodeposition baths, current densities, and observation of voids are set forth in Table 2. Void counts for the dense region are graphically illustrated in Fig. 8, void counts for the ISO region are graphically illustrated in Fig. 9 and the sum of dense and ISO void counts are illustrated in Fig. 10.

**Table 2**

| **ECD Conditions** | | | | **Dense Top View Voids** | | | | **ISO Top View Voids** | | | | **Dense+ISO** |
|---|---|---|---|---|---|---|---|---|---|---|---|---|
| Split | SPS * Accelerator | Suppressor * | Leveler * | CR | SW | MM | All Dense | CR | SW | MM | All ISO | Dense+ISO |
| 1 | 82 mg/L | 13 (200 mg/L) | II (2.1 mg/L) | 19 | 14 | 0 | 33 | 5 | 10 | 0 | 15 | 48 |
| 2 | 82 mg/L | 13 (200 mg/L) | II (1.4 mg/L) | 21 | 18 | 1 | 40 | 6 | 8 | 0 | 14 | 54 |
| 3 | 82 mg/L | 13 (200 mg/L) | III (2.8 mg/L) | 37 | 7 | 0 | 44 | 15 | 5 | 0 | 20 | 64 |
| 4 | 82 mg/L | 13 (200 mg/L) | III (4.2 mg/L) | 64 | 29 | 0 | 93 | 67 | 51 | 0 | 118 | 211 |
| 5 | 82 mg/L | 13 (200 mg/L) | III (8.4 mg/L) | 101 | 14 | 0 | 115 | 95 | 30 | 0 | 125 | 240 |
| 6 | 82 mg/L | 13 (200 mg/L) | V (19.6 mg/L) | 164 | 58 | 3 | 225 | 147 | 18 | 0 | 165 | 390 |
| 7 | 82 mg/L | 13 (200 mg/L) | V (25.2 mg/L) | 354 | 42 | 0 | 396 | 294 | 12 | 0 | 306 | 702 |
| 8 | 82 mg/L | 13 (200 mg/L) | V (30.8 mg/L) | 109 | 15 | 0 | 124 | 227 | 6 | 0 | 233 | 357 |
| 9 | 82 mg/L | 13 (200 mg/L) | IV (2.8 mg/L) | 20 | 5 | 0 | 25 | 10 | 4 | 0 | 14 | 39 |
| 10 | 82 mg/L | 13 (200 mg/L) | IV (4.2 mg/L) | 18 | 5 | 0 | 23 | 51 | 23 | 0 | 74 | 97 |
| 11 | 82 mg/L | 13 (200 mg/L) | IV (8.4 mg/L) | 73 | 15 | 0 | 88 | 73 | 7 | 0 | 80 | 168 |

| | | | | | | | | | | | | |
|---|---|---|---|---|---|---|---|---|---|---|---|---|
| ISO = isolated via chain Dense = more dense via chain region CR = center voids SW = side wall voids MM = missing metal | | | | | | | | | | | | |

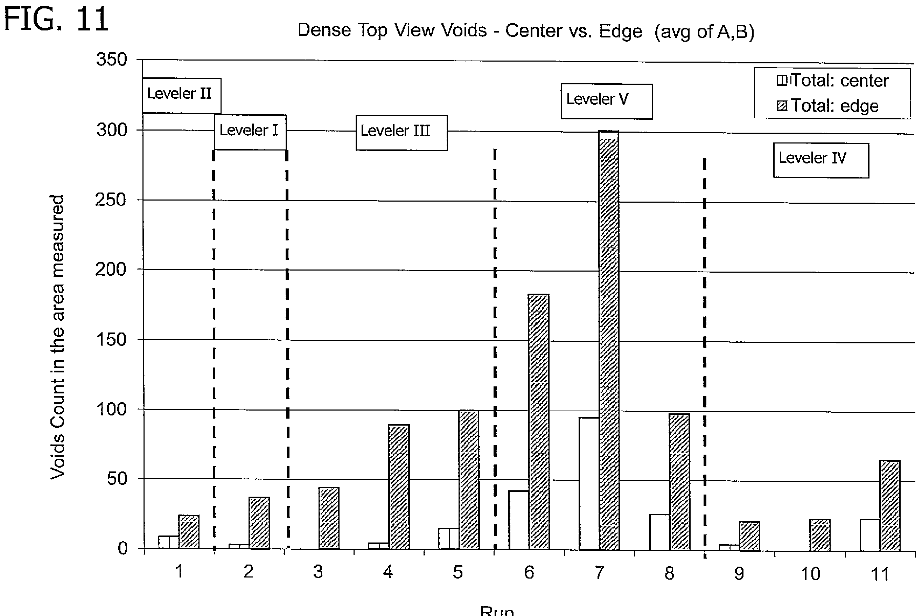

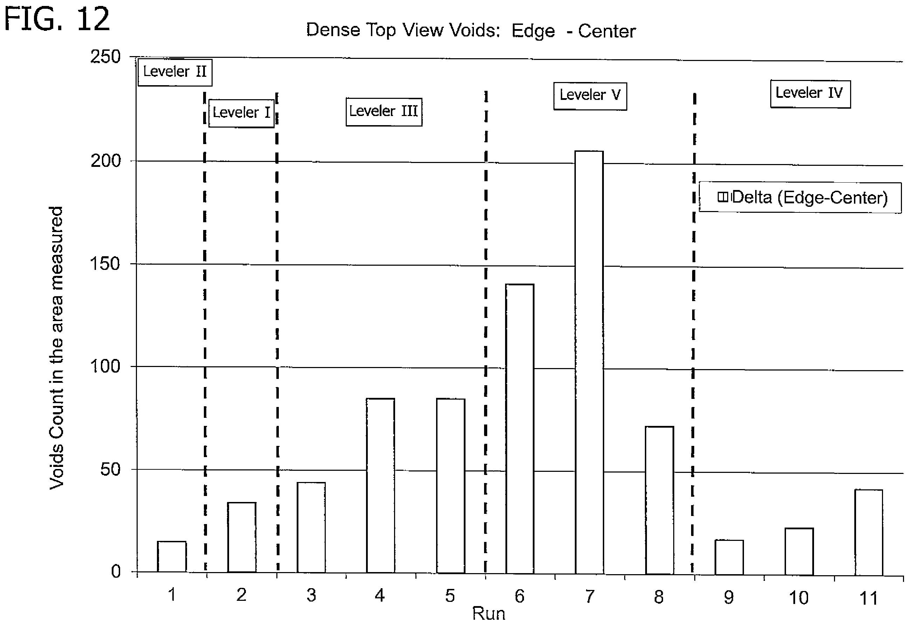

Fig. 11 graphically illustrates the prevalence of voids in the center and edge of the Dense region for the runs of this Example, and Fig. 12 illustrates the difference between edge and center voids.

When introducing elements of the present invention or the preferred embodiment(s) thereof, the articles "a", "an", "the" and "said" are intended to mean that there are one or more of the elements. For example, that the foregoing description and following claims refer to "an" interconnect means that there are one or more such interconnects. The terms "comprising", "including" and "having" are intended to be inclusive and mean that there may be additional elements other than the listed elements.

As used herein, the term "about" refers to a measurable value such as a parameter, an amount, a temporal duration, and the like and is meant to include variations of +/-15 % or less, preferably variations of +/-10 % or less, more preferably variations of +/-5 % or less, even more preferably variations of +/-1 % or less, and still more preferably variations of +/-0.1 % or less of and from the particularly recited value, in so far as such variations are appropriate to perform in the invention described herein. Furthermore, it is also to be understood that the value to which the modifier "about" refers is itself specifically disclosed herein.

As used herein, the term "immediately," including "immediately before" or "immediately after" refers to a time period that is within one day, more preferably within several hours, more preferably within one hour, and still more preferably within several minutes.

As various changes could be made in the above without departing from the scope of the invention, it is intended that all matter contained in the above description and shown in the accompanying drawings shall be interpreted as illustrative and not in a limiting sense. The scope of invention is defined by the appended claims and modifications to the embodiments above may be made that do not depart from the scope of the invention.

## Claims

1. An electrolytic plating composition for superfilling submicron features in a semiconductive integrated circuit device, the composition comprising a source of copper ions in an amount sufficient to electrolytically deposit copper onto a substrate and into the electrical interconnect features and a suppressor comprising a polyether bonded to a nitrogen of an oligo(alkylene imine) or quaternized oligo(alkylene imine) having at least three amine sites, said polyether comprising a block copolymer substituent comprising propylene oxide (PO) repeat units and ethylene oxide (EO) repeat units, wherein said suppressor corresponds to the structure: 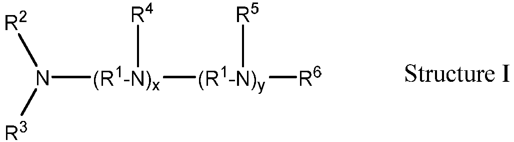 wherein x is an integer between 0 and 4, y is an integer between 0 and 4, x+y is an integer between 2 and 6, R¹ comprises an alkylene group, at least one of R², R³, R⁴, R⁵ and R⁶ comprises a polyether substituent comprising a block copolymer of propylene oxide and ethylene oxide, wherein a linear portion of the polyether substituent comprises a block of EO repeat units bonded to a block of PO repeat units, wherein each of the remainder of R², R³, R⁴, R⁵ and R⁶ is selected from the group consisting of hydrogen, lower alkyl, aminoalkyl, hydroxyalkyl and a polyether substituent comprising propylene oxide (PO) repeat units, ethylene oxide (EO) repeat units, or a combination of PO and EO repeat units, wherein the molecular weight of the suppressor compound is between 6,000 and 12,000 and the concentration of the suppressor in the electrolytic plating composition is between 50 and 200 mg/L.

2. The composition according to claim 1, wherein the ratio of propylene oxide (PO) repeat units to ethylene oxide (EO) repeat units in the suppressor molecule as a whole is between 0.25:1 and 1.4:1, or wherein at least two of R², R³, R⁴, R⁵ and R⁶ comprise polyether substituents, each comprising the block copolymer of propylene oxide and ethylene oxide, and the ratio of propylene oxide (PO) repeat units to ethylene oxide (PO) repeat units in the suppressor molecule is between 2:8 and 7:3, preferably between 4:6 and 6:4.

3. The composition according to claim 1, wherein the ratio of propylene oxide (PO) repeat units to ethylene oxide (EO) repeat units in the suppressor molecule as a whole is between 2:8 and 7:3.

4. The composition according to claim 1, wherein
(i) the oligo(alkylene imine) or quaternized oligo(alkylene imine) comprises at least four amine sites; or
(ii) said suppressor comprises an alkoxylated and quaternized oligo(alkylene imine).

5. The composition as set forth in claim 1, wherein:
(i) each of R², R³, R⁴, R⁵ and R⁶ comprises a polyether substituent that comprises a block copolymer of propylene oxide and ethylene oxide;
(ii) the ratio of PO/EO repeat units in each polyether substituent is between 0:25:1 and 1.1:1;
(iii) the molecular weight of said suppressor is between 6,500 and 10,000;
(iv) x+y = 2, x+y = 3, or x+y = 4; or
(v) R¹ contains between 2 and 6 carbon atoms, and the suppressor comprises alkoxylated diethylene triamine, alkoxylated triethylene tetraamine, or alkoxylated tetraethylene pentamine.

6. The composition as set forth in claim 1, wherein the electrolytic plating composition further comprises an accelerator.

7. The composition as set forth in claim 1, wherein:
(i) each polyether substituent comprises a polypropylene oxide block or propylene oxide unit bonded directly to a nitrogen;
(ii) each of said polyether substituents of said suppressor comprises a terminal exterior block comprising at least 5, preferably at least 10 ethylene oxide (EO) repeat units bonded to a relatively more interior block comprising at least 5 propylene oxide (PO) repeat units;
(iii) each of said polyether substituents of said suppressor comprises a terminal exterior block comprising at least 5 propylene oxide (PO) repeat units bonded to a relatively more interior block comprising at least 10 ethylene oxide (EO) repeat units;
or
(iv) at least one polyether substituent comprises a tri-block PO-EO-PO copolymer.

8. The composition as set forth in claim 1, further comprising a leveler, optionally wherein said leveler comprises: 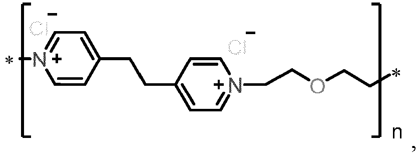 wherein n is between 5 and 15, further optionally wherein n is 7 or 8 or 9 or 10, yet further optionally wherein said leveler comprises the polymeric or oligomeric reaction product of: 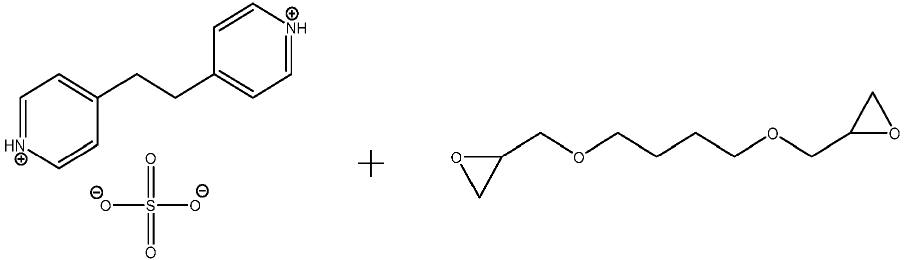 or the reaction product of the diglycidyl ether of 1,4-butane diol with another salt of 1,2-di(4-pyridyl)ethane and a compatible anion.

9. A composition as set forth in claim 1, wherein said suppressor is selected from the group consisting of: 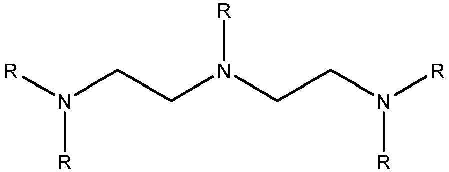 where 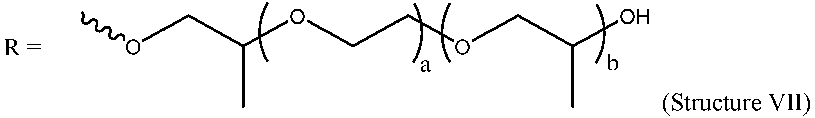 wherein a has an average value between 10 and 14, b has an average value between 12 and 16, the molar ratio of PO units to EO units is between 1:1 and 1.3:1 and the molecular weight is between 6,500 and 7,500; 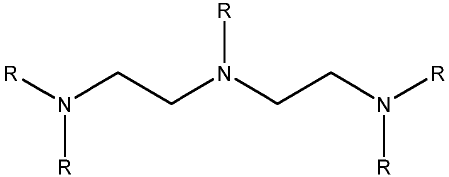 where 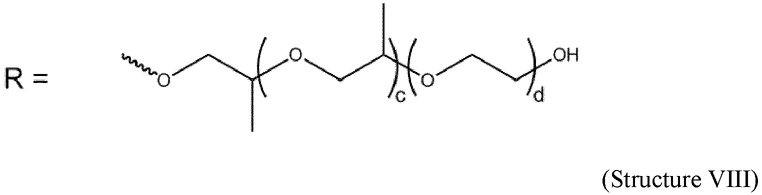 wherein c has an average value between 12 and 16, d has an average value between 10 and 14, the molar ratio of PO units to EO units is between 1.1:1 and 1.3:1, and the molecular weight is between 6,500 and 7,500; 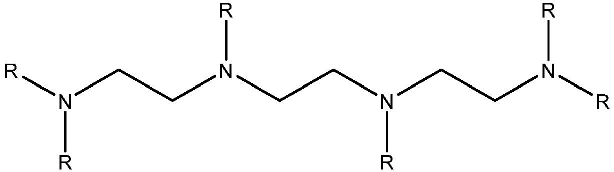 where 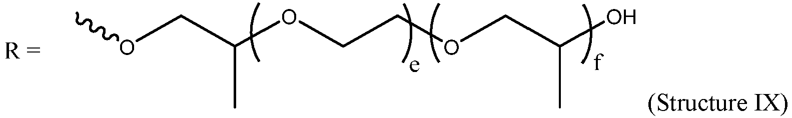 wherein e has an average value between 10 and 14, f has an average value between 6 and 9, the molar ratio of PO units to EO units is between 0.5:1 and 0.7:1 and the molecular weight is between 6,500 and 7,500; 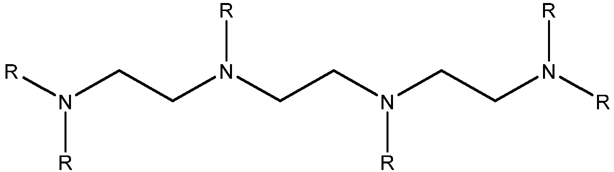 where 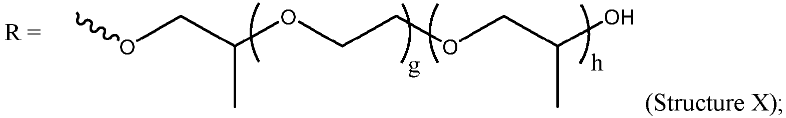 wherein g has an average value between 18 and 24, h has an average value between 9 and 12, the molar ratio of PO units to EO units is between 0.4:1 and 0.7:1, and the molecular weight is between 9,000 and 11,000; and 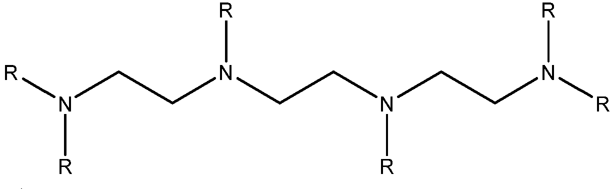 where: 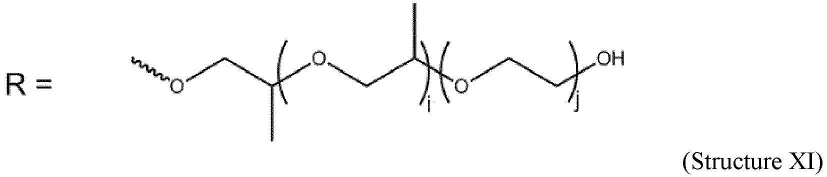 wherein i has an average value between 6 and 9, j has an average value between 14 and 16, the molar ratio of PO units to EO units is between 0.5:1 and 0.7:1 and the molecular weight is between 6,500 and 7,500.

10. The composition as set forth in claim 1, wherein said composition comprises bis-(3-sodium sulfopropyl disulfide), having the acronym SPS, in a concentration between 35 and 100 mg/L.

11. The composition as set forth in claim 10, wherein said suppressor is selected from the group consisting of: 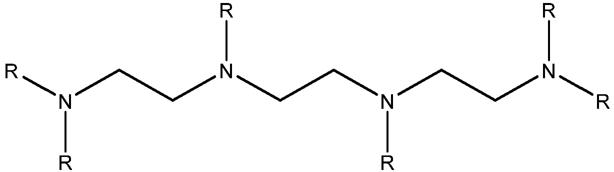 where 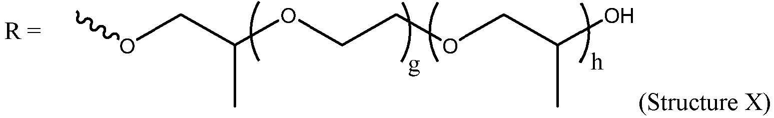 and g has an average value between 18 and 24, h has an average value between 9 and 12, the molar ratio of PO units to EO units is between 0.4:1 and 0.7:1 and the molecular weight is between 6,500 and 7,500; 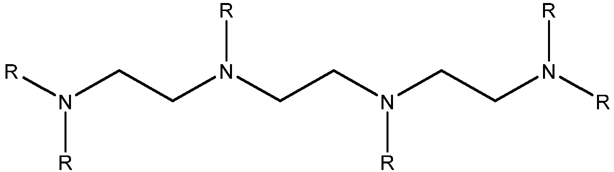 where 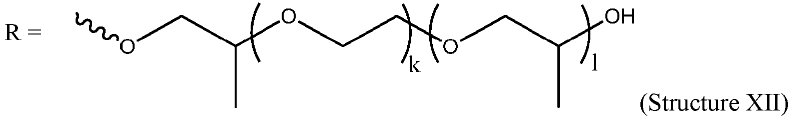 and k has an average value between 15 and 20, 1 has an average value between 3 and 7, the molar ratio of PO units to EO units is between and 0.25:1 and 0.4:1 and the molecular weight is between 9,000 and 11,000; and 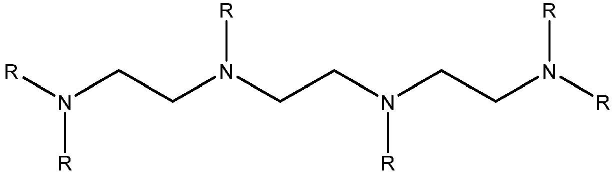 where: 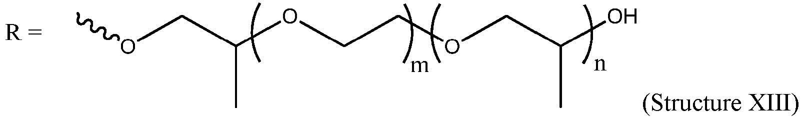 and m has an average value between 10 and 14, n has an average value between 8 and 12, the molar ratio of PO units to EO units is between 0.8:1 and 1.0:1 and the molecular weight is between 6,500 and 7,500.

12. The composition as set forth in claim 1, wherein said suppressor is selected from the group consisting of: 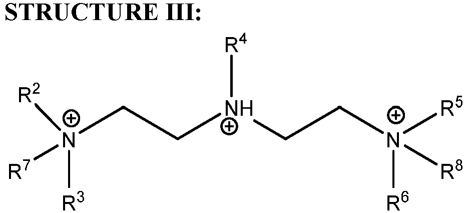 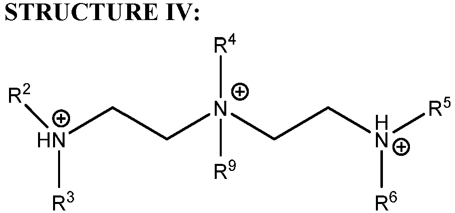 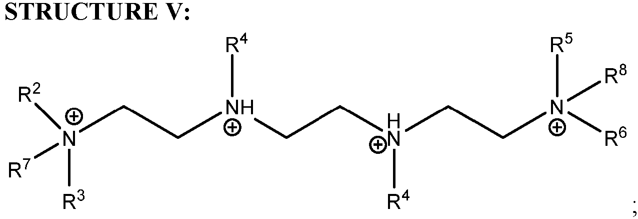 and 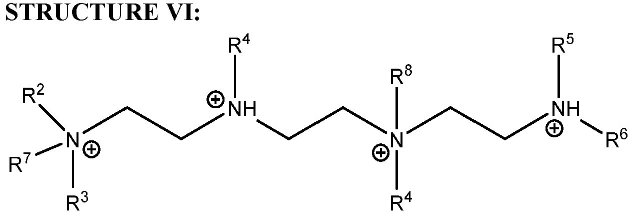 wherein at least one of R², R³, R⁴, R⁵ and R⁶ comprises a polyether substituent comprising a block copolymer of propylene oxide and ethylene oxide wherein the ratio of propylene oxide (PO) repeat units to ethylene oxide (PO) repeat units is between 0.25:1 and 1.4:1, each of the remainder of R², R³, R⁴, R⁵ and R⁶ is selected from the group consisting of hydrogen, lower alkyl, aminoalkyl, hydroxyalkyl and a polyether substituent comprising propylene oxide (PO) repeat units, ethylene oxide (EO) repeat units, or a combination of PO and EO repeat units, each of R⁷ and R⁸ is selected from the group consisting of alkyl, aryl, aralkyl, alkenyl, and a proton, and at least one of R⁷ and R⁸ is other than a proton, R⁹ is selected from the group consisting of alkyl, aryl, aralkyl, and alkenyl.

13. The composition as set forth in claim 3, wherein
(i) the ratio of propylene oxide (PO) repeat units to ethylene oxide (EO) repeat units is between 3:7 and 6:5, optionally wherein the ratio of propylene oxide (PO) repeat units to ethylene oxide (EO) repeat units is between 1:3 and 1.0:1;
(ii) the ratio of propylene oxide (PO) repeat units to ethylene oxide (EO) repeat units is between 4:6 and 6:4;
(iii) at least two of R², R³, R⁴, R⁵ and R⁶ comprise polyether substituents, each comprising a block copolymer of propylene oxide and ethylene oxide, and the ratio of propylene oxide (PO) repeat units to ethylene oxide (EO) repeat units in the suppressor molecule is between 4:6 and 6:4; or
(iv) at least two of R², R³, R^{4,} R⁵ and R⁶ optionally comprise polyether substituents, each comprising a block copolymer of propylene oxide and ethylene oxide, and the ratio of propylene oxide (PO) repeat units to ethylene oxide (EO) repeat units in each polyether substituent is between 2:8 and 7:3, or between 3:7 and 6:5, or between 1:3 and 1.0:1, or between 4:6 and 6:4.

## Patentansprüche

1. Zusammensetzung zum elektrolytischen metallischen Verstärken zum Superfüllen von Submikronmerkmalen in einer halbleitenden integrierten Schaltungsvorrichtung, die Zusammensetzung umfassend eine Quelle von Kupferionen in einer Menge, die ausreicht, um Kupfer auf ein Substrat und in die elektrischen Verkopplungsmerkmale elektrolytisch abzuscheiden, und einen Suppressor, umfassend einen Polyether, der an einen Stickstoff eines Oligo(alkylenimin) oder quaternisierten Oligo(alkylenimin) gebunden ist, der mindestens drei Aminstellen aufweist, der Polyether umfassend einen Blockcopolymer-Substituenten, umfassend Propylenoxidwiederholungseinheiten (PO-Wiederholungseinheiten) und Ethylenoxidwiederholungseinheiten (EO-Wiederholungseinheiten), wobei der Suppressor der Struktur entspricht: 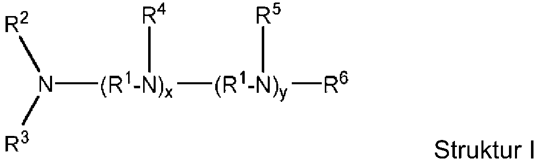 wobei x eine ganze Zahl zwischen 0 und 4 ist, y eine ganze Zahl zwischen 0 und 4 ist, x+y eine ganze Zahl zwischen 2 und 6 ist, R¹ eine Alkylengruppe umfasst, mindestens einer von R², R³, R⁴, R⁵ und R⁶ einen Polyethersubstituenten umfasst, umfassend ein Blockcopolymer aus Propylenoxid und Ethylenoxid, wobei ein linearer Abschnitt des Polyethersubstituenten einen Block aus EO-Wiederholungseinheiten umfasst, der an einen Block aus PO-Wiederholungseinheiten gebunden ist, wobei jeder der verbleibenden von R², R³, R⁴, R⁵ und R⁶ aus der Gruppe ausgewählt ist, bestehend aus Wasserstoff, niedrigem Alkyl, Aminoalkyl, Hydroxyalkyl und einem Polyethersubstituenten, umfassend Propylenoxidwiederholungseinheiten (PO-Wiederholungseinheiten), Ethylenoxidwiederholungseinheiten (EO-Wiederholungseinheiten) oder eine Kombination aus PO- und EO-Wiederholungseinheiten, wobei das Molekulargewicht der Suppressorverbindung zwischen 6.000 und 12.000 liegt und die Konzentration des Suppressors in der Zusammensetzung zum elektrolytischen metallischen Verstärken zwischen 50 und 200 mg/L liegt.

2. Zusammensetzung nach Anspruch 1, wobei das Verhältnis von Propylenoxidwiederholungseinheiten (PO-Wiederholungseinheiten) zu Ethylenoxidwiederholungseinheiten (EO-Wiederholungseinheiten) in dem Suppressormolekül als ein Ganzes zwischen 0,25: 1 und 1,44:1 liegt, oder
wobei mindestens zwei von R², R³, R⁴, R⁵ und R⁶ Polyethersubstituenten umfassen, jeweils umfassend das Blockcopolymer aus Propylenoxid und Ethylenoxid, und das Verhältnis von Propylenoxidwiederholungseinheiten (PO-Wiederholungseinheiten) zu Ethylenoxidwiederholungseinheiten (PO-Wiederholungseinheiten) in dem Suppressormolekül zwischen 2: 8 und 77:3, vorzugsweise zwischen 4 4: und 6 :6: liegt.

3. Zusammensetzung nach Anspruch 1, wobei das Verhältnis von Propylenoxidwiederholungseinheiten (PO-Wiederholungseinheiten) zu Ethylenoxidwiederholungseinheiten (EO-Wiederholungseinheiten) in dem Suppressormolekül als ein Ganzes zwischen 2: 8 und 7: 3 liegt.

4. Zusammensetzung nach Anspruch 1, wobei
(i) das Oligo(alkylenimine) oder quaternisierte Oligo(alkylenimine) mindestens vier Amingruppen umfasst; oder
(ii) wobei der Suppressor ein alkoxyliertes und quaternisiertes Oligo(alkylenimine) umfasst.

5. Zusammensetzung nach Anspruch 1, wobei:
(i) jeder von R², R³, R⁴, R⁵ und R⁶ einen Polyethersubstituenten umfasst, der ein Blockcopolymer aus Propylenoxid und Ethylenoxid umfasst;
(ii) das Verhältnis von PO/EO-Wiederholungseinheiten in jedem Polyethersubstituenten zwischen 0:25 : 1 und 1,1 : 1 liegt;
(iii) das Molekulargewicht des Suppressors zwischen 6.500 und 10.000 liegt;
(iv) x+y = 2, x+y = 3 oder x+y = 4; oder
(v) R¹ zwischen 2 und 6 Kohlenstoffatome enthält, und der Suppressor alkoxyliertes Diethylentriamin, alkoxyliertes Triethylentetraamin oder alkoxyliertes Tetraethylenpentamin umfasst.

6. Zusammensetzung nach Anspruch 1, wobei die Zusammensetzung zum elektrolytischen metallischen Verstärken ferner einen Beschleuniger umfasst.

7. Zusammensetzung nach Anspruch 1, wobei:
(i) jeder Polyethersubstituent einen Polypropylenoxidblock oder eine Propylenoxideinheit umfasst, die direkt an einen Stickstoff gebunden ist;
(ii) jeder der Polyethersubstituenten des Suppressors einen terminalen äußeren Block, umfassend mindestens 5, vorzugsweise mindestens 10 Ethylenoxidwiederholungseinheiten (EO-Wiederholungseinheiten), die an einen relativ weiter inneren Block gebunden sind, umfassend mindestens 5 Propylenoxidwiederholungseinheiten (PO-Wiederholungseinheiten), umfasst;
(iii) jeder der Polyethersubstituenten des Suppressors einen terminalen äußeren Block, umfassend mindestens 5 Propylenoxidwiederholungseinheiten (PO-Wiederholungseinheiten), die an einen relativ weiter inneren Block gebunden sind, umfassend mindestens 10 Ethylenoxidwiederholungseinheiten (EO-Wiederholungseinheiten), umfasst; oder
(iv) mindestens ein Polyethersubstituent einen Tri-Block-PO-EO-PO-Copolymer umfasst.

8. Zusammensetzung nach Anspruch 1, ferner umfassend einen Einebner, optional wobei der Einebner umfasst: 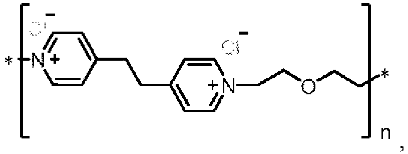 wobei n zwischen 5 und 15 liegt, ferner optional wobei n 7 oder 8 oder 9 oder 10 ist, noch ferner optional wobei der Einebner das polymere oder oligomere Reaktionsprodukt umfasst von: 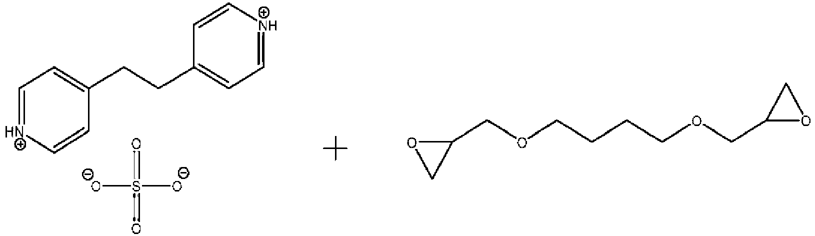 oder das Reaktionsprodukt des Diglycidylethers von 1,4-Butandiol mit einem anderen Salz von 1,2-Di(4-pyridyl)ethan und einem kompatiblen Anion.

9. Zusammensetzung nach Anspruch 1, wobei der Suppressor aus der Gruppe ausgewählt ist, bestehend aus: 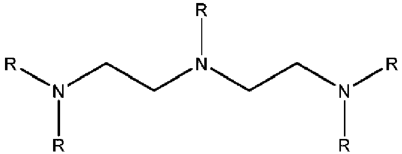 wobei 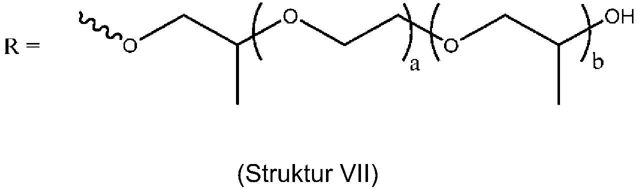 wobei a einen durchschnittlichen Wert zwischen 10 und 14 aufweist, b einen durchschnittlichen Wert zwischen 12 und 16 aufweist, das Molverhältnis von PO-Einheiten zu EO-Einheiten zwischen 1 : 1 und 1,3 : 1 liegt und das Molekulargewicht zwischen 6.500 und 7.500 liegt; 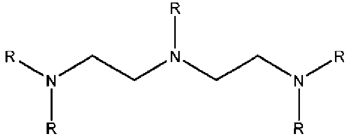 wobei 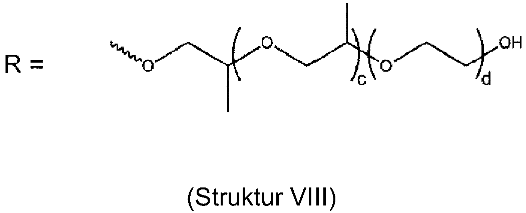 wobei c einen durchschnittlichen Wert zwischen 12 und 16 aufweist, d einen durchschnittlichen Wert zwischen 10 und 14 aufweist, das Molverhältnis von PO-Einheiten zu EO-Einheiten zwischen 1,1 : 1 und 1,3 : 1 liegt und das Molekulargewicht zwischen 6.500 und 7.500 liegt; 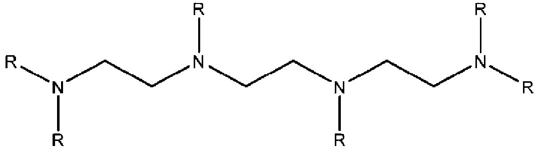 wobei 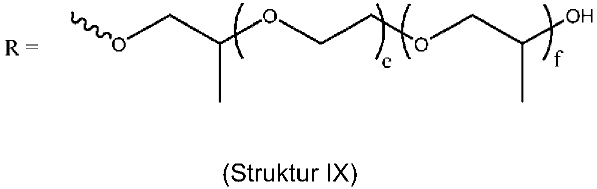 wobei e einen durchschnittlichen Wert zwischen 10 und 14 aufweist, f einen durchschnittlichen Wert zwischen 6 und 9 aufweist, das Molverhältnis von PO-Einheiten zu EO-Einheiten zwischen 0,5 : 1 und 0,7 : 1 liegt und das Molekulargewicht zwischen 6.500 und 7.500 liegt; 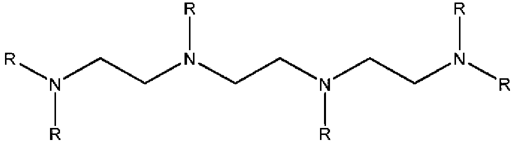 wobei 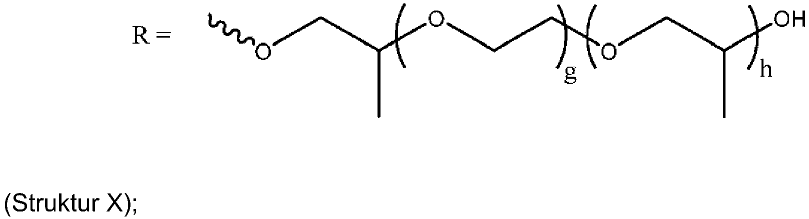 wobei g einen durchschnittlichen Wert zwischen 18 und 24 aufweist, h einen durchschnittlichen Wert zwischen 9 und 12 aufweist, das Molverhältnis von PO-Einheiten zu EO-Einheiten zwischen 0,4 : 1 und 0,7 : 1 liegt und das Molekulargewicht zwischen 9.000 und 11.000 liegt; und 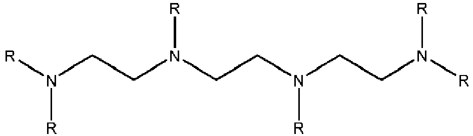 wobei: 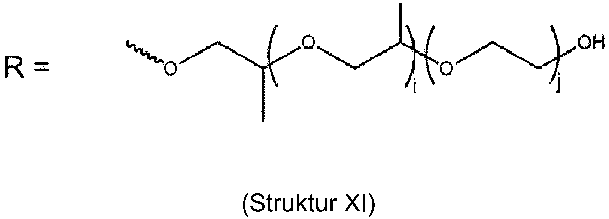 wobei i einen durchschnittlichen Wert zwischen 6 und 9 aufweist, j einen durchschnittlichen Wert zwischen 14 und 16 aufweist, das Molverhältnis von PO-Einheiten zu EO-Einheiten zwischen 0,5 : 1 und 0,7 : 1 liegt und das Molekulargewicht zwischen 6.500 und 7.500 liegt.

10. Zusammensetzung nach Anspruch 1, wobei die Zusammensetzung Bis-(3-natriumsulfopropyl-disulfid), das das Akronym SPS aufweist, in einer Konzentration zwischen 35 und 100 mg/L umfasst.

11. Zusammensetzung nach Anspruch 10, wobei der Suppressor aus der Gruppe ausgewählt ist, bestehend aus: 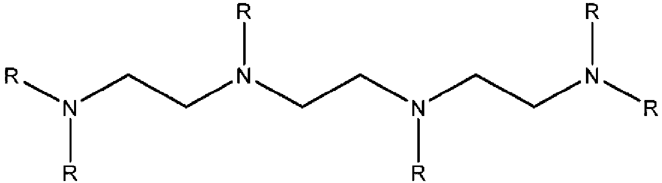 wobei 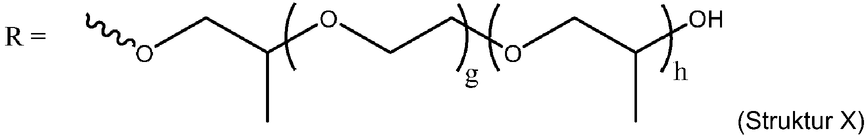 und g einen durchschnittlichen Wert zwischen 18 und 24 aufweist, h einen durchschnittlichen Wert zwischen 9 und 12 aufweist, das Molverhältnis von PO-Einheiten zu EO-Einheiten zwischen 0,4 : 1 und 0,7 : 1 liegt und das Molekulargewicht zwischen 6.500 und 7.500 liegt; 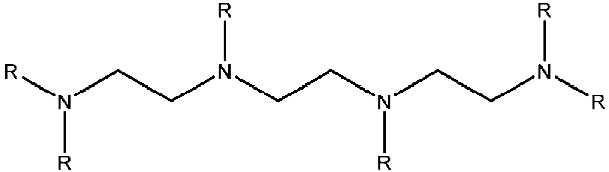 wobei 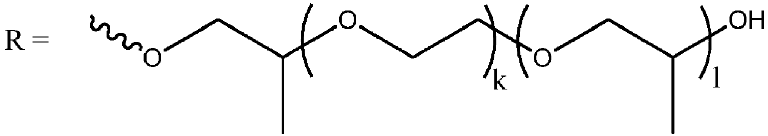 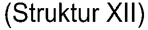 und k einen durchschnittlichen Wert zwischen 15 und 20 aufweist, l einen durchschnittlichen Wert zwischen 3 und 7 aufweist, das Molverhältnis von PO-Einheiten zu EO-Einheiten zwischen 0,25 : 1 und 0,4 : 1 liegt und das Molekulargewicht zwischen 9.000 und 11.000 liegt; und 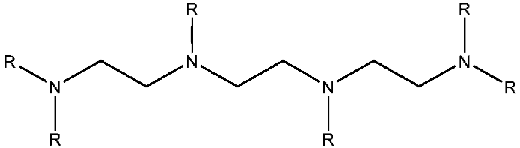 wobei: 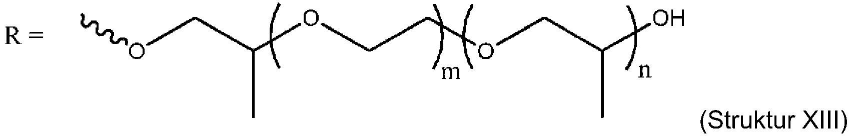 und m einen durchschnittlichen Wert zwischen 10 und 14 aufweist, n einen durchschnittlichen Wert zwischen 8 und 12 aufweist, das Molverhältnis von PO-Einheiten zu EO-Einheiten zwischen 0,8 : 1 und 1,0 : 1 liegt und das Molekulargewicht zwischen 6.500 und 7.500 liegt.

12. Zusammensetzung nach Anspruch 1, wobei der Suppressor aus der Gruppe ausgewählt ist, bestehend aus: 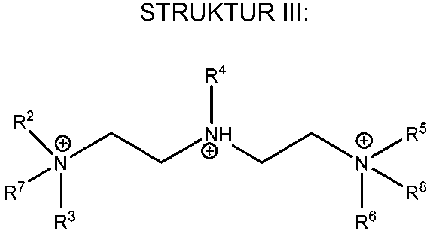 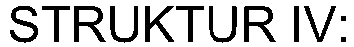 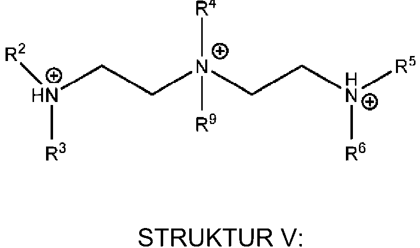 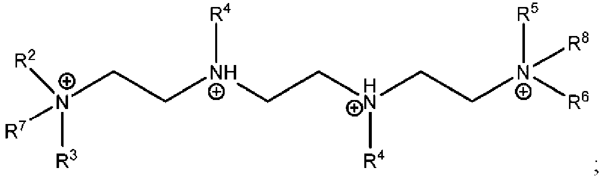 und 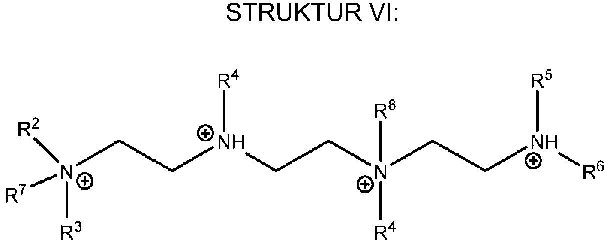 wobei mindestens einer von R², R³, R⁴, R⁵ und R⁶ einen Polyethersubstituenten umfasst, umfassend ein Blockcopolymer aus Propylenoxid und Ethylenoxid, wobei das Verhältnis von Propylenoxidwiederholungseinheiten (PO-Wiederholungseinheiten) zu Ethylenoxidwiederholungseinheiten (PO-Wiederholungseinheiten) zwischen 0,25 : 1 und 1,4 : 1 liegt, jeder der verbleibenden von R², R³, R⁴, R⁵ und R⁶ aus der Gruppe ausgewählt ist, bestehend aus Wasserstoff, niedrigem Alkyl, Aminoalkyl, Hydroxyalkyl und einem Polyethersubstituenten, umfassend Propylenoxidwiederholungseinheiten (PO-Wiederholungseinheiten), Ethylenoxidwiederholungseinheiten (EO-Wiederholungseinheiten) oder eine Kombination von PO- und EO-Wiederholungseinheiten, jeder von R⁷ und R⁸ aus der Gruppe ausgewählt ist, bestehend aus Alkyl, Aryl, Aralkyl, Alkenyl und einem Proton, und mindestens einer von R⁷ und R⁸ etwas anderes als ein Proton ist, R⁹ aus der Gruppe ausgewählt ist, bestehend aus Alkyl, Aryl, Aralkyl und Alkenyl.

13. Zusammensetzung nach Anspruch 3, wobei
(i) das Verhältnis von Propylenoxidwiederholungseinheiten (PO-Wiederholungseinheiten) zu Ethylenoxidwiederholungseinheiten (EO-Wiederholungseinheiten) zwischen 3 : 7 und 6 : 5 liegt, optional wobei das Verhältnis von Propylenoxidwiederholungseinheiten (PO-Wiederholungseinheiten) zu Ethylenoxidwiederholungseinheiten (EO-Wiederholungseinheiten) zwischen 1 : 3 und 1,0 : 1 liegt;
(ii) das Verhältnis von Propylenoxidwiederholungseinheiten (PO-Wiederholungseinheiten) zu Ethylenoxidwiederholungseinheiten (EO-Wiederholungseinheiten) zwischen 4 : 6 und 6 : 4 liegt;
(iii) mindestens zwei von R², R³, R⁴, R⁵ und R⁶ Polyethersubstituenten umfassen, jeweils umfassend ein Blockcopolymer aus Propylenoxid und Ethylenoxid, und das Verhältnis von Propylenoxidwiederholungseinheiten (PO-Wiederholungseinheiten) zu Ethylenoxidwiederholungseinheiten (EO-Wiederholungseinheiten) in dem Suppressormolekül zwischen 4 : 6 und 6 : 4 liegt; oder
(iv) mindestens zwei von R², R³, R⁴, R⁵ und R⁶ optional Polyethersubstituenten umfassen, jeweils umfassend ein Blockcopolymer aus Propylenoxid und Ethylenoxid, und das Verhältnis von Propylenoxidwiederholungseinheiten (PO-Wiederholungseinheiten) zu Ethylenoxidwiederholungseinheiten (EO-Wiederholungseinheiten) in jedem Polyethersubstituenten zwischen 2 : 8 und 7 : 3 oder zwischen 3 : 7 und 6 : 5 oder zwischen 1 : 3 und 1,0 : 1 oder zwischen 4 : 6 und 6 : 4 liegt.

## Revendications

1. Composition de placage électrolytique permettant de remplir en excès des caractéristiques submicroniques dans un dispositif de circuit intégré semiconducteur, la composition comprenant une source d'ions cuivre en une quantité suffisante pour déposer par voie électrolytique du cuivre sur un substrat et dans les caractéristiques d'interconnexion électrique et un suppresseur comprenant un polyéther lié à un azote d'une oligo(alkylène imine) ou oligo(alkylène imine) quaternisée ayant au moins trois sites amine, ledit polyéther comprenant un substituant de copolymère à blocs comprenant des motifs répétitifs d'oxyde de propylène (PO) et des motifs répétitifs d'oxyde d'éthylène (EO), dans laquelle ledit suppresseur correspond à la structure : 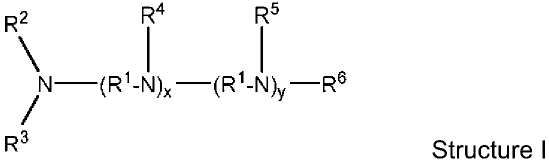 dans laquelle x est un entier compris entre 0 et 4, y est un entier compris entre 0 et 4, x + y est un entier compris entre 2 et 6, R¹ comprend un groupe alkylène, au moins l'un parmi R², R³, R⁴, R⁵ et R⁶ comprend un substituant de polyéther comprenant un copolymère à blocs d'oxyde de propylène et d'oxyde d'éthylène, dans laquelle une partie linéaire du substituant de polyéther comprend un bloc de motifs répétitifs EO lié à un bloc de motifs répétitifs PO, dans laquelle chacun du reste de R², R³, R⁴, R⁵ et R⁶ est choisi dans le groupe constitué d'hydrogène, alkyle inférieur, aminoalkyle, hydroxyalkyle et un substituant de polyéther comprenant des motifs répétitifs d'oxyde de propylène (PO), des motifs répétitifs d'oxyde d'éthylène (EO), ou une combinaison de motifs répétitifs PO et EO, dans laquelle la masse moléculaire du composé suppresseur est comprise entre 6 000 et 12 000 et la concentration du suppresseur dans la composition de placage électrolytique est comprise entre 50 et 200 mg/L.

2. Composition selon la revendication 1, dans laquelle le rapport entre motifs répétitifs d'oxyde de propylène (PO) et motifs répétitifs d'oxyde d'éthylène (EO) dans la molécule de suppresseur dans son ensemble est compris entre 0,25:1 et 1,4:1, ou
dans laquelle au moins deux parmi R², R³, R⁴, R⁵ et R⁶ comprennent des substituants de polyéther, chacun comprenant le copolymère à blocs d'oxyde de propylène et d'oxyde d'éthylène, et le rapport entre motifs répétitifs d'oxyde de propylène (PO) et motifs répétitifs d'oxyde d'éthylène (PO) dans la molécule de suppresseur est compris entre 2:8 et 7:3, de préférence entre 4:6 et 6:4.

3. Composition selon la revendication 1, dans laquelle le rapport entre motifs répétitifs d'oxyde de propylène (PO) et motifs répétitifs d'oxyde d'éthylène (EO) dans la molécule de suppresseur dans son ensemble est compris entre 2:8 et 7:3.

4. Composition selon la revendication 1, dans laquelle
(i) l'oligo(alkylène imine) ou oligo(alkylène imine) quaternisée comprend au moins quatre sites amine ; ou
(ii) ledit suppresseur comprend une oligo(alkylène imine) alcoxylée et quaternisée.

5. Composition selon la revendication 1, dans laquelle :
(i) chacun de R², R³, R⁴, R⁵ et R⁶ comprend un substituant de polyéther qui comprend un copolymère à blocs d'oxyde de propylène et d'oxyde d'éthylène ;
(ii) le rapport de motifs répétitifs PO/EO dans chaque substituant de polyéther est compris entre 0:25:1 et 1,1:1 ;
(iii) la masse moléculaire dudit suppresseur est comprise entre 6 500 et 10 000 ;
(iv) x + y = 2, x + y = 3 ou x + y = 4 ; ou
(v) R¹ contient entre 2 et 6 atomes de carbone, et le suppresseur comprend de la diéthylène triamine alcoxylée, de la triéthylène tétraamine alcoxylée, ou de la tétraéthylène pentamine alcoxylée.

6. Composition selon la revendication 1, dans laquelle la composition de placage électrolytique comprend en outre un accélérateur.

7. Composition selon la revendication 1, dans laquelle :
(i) chaque substituant de polyéther comprend un bloc oxyde de polypropylène ou un motif oxyde de propylène lié directement à un azote ;
(ii) chacun desdits substituants de polyéther dudit suppresseur comprend un bloc extérieur terminal comprenant au moins 5, de préférence au moins 10 motifs répétitifs d'oxyde d'éthylène (EO) lié à un bloc relativement plus intérieur comprenant au moins 5 motifs répétitifs d'oxyde de propylène (PO) ;
(iii) chacun desdits substituants de polyéther dudit suppresseur comprend un bloc extérieur terminal comprenant au moins 5 motifs répétitifs d'oxyde de propylène (PO) lié à un bloc relativement plus intérieur comprenant au moins 10 motifs répétitifs d'oxyde d'éthylène (EO) ; ou
(iv) au moins un substituant de polyéther comprend un copolymère à trois blocs PO-EO-PO.

8. Composition selon la revendication 1, comprenant en outre un agent nivelant, facultativement dans laquelle ledit agent nivelant comprend : 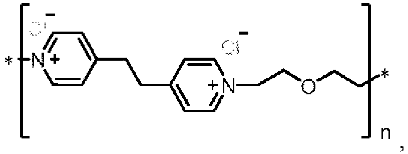 dans laquelle n est compris entre 5 et 15, facultativement en outre dans laquelle n vaut 7 ou 8 ou 9 ou 10, encore facultativement en outre dans laquelle ledit agent nivelant comprend le produit polymère ou oligomère de réaction de : 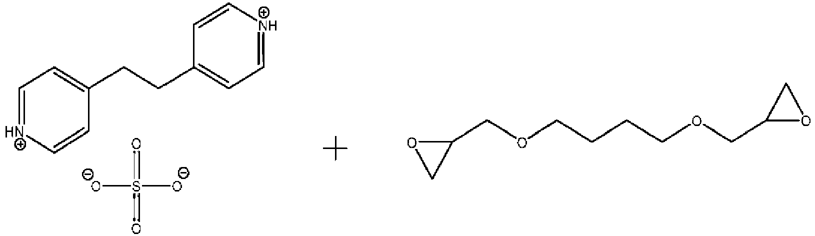 ou le produit de réaction de l'éther diglycidylique de 1,4-butane-diol avec un autre sel de 1,2-di(4-pyridyl)éthane et un anion compatible.

9. Composition selon la revendication 1, dans laquelle ledit suppresseur est choisi dans le groupe constitué de : 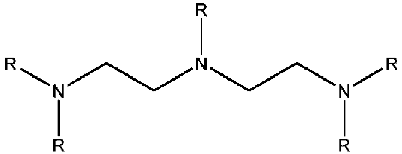 où 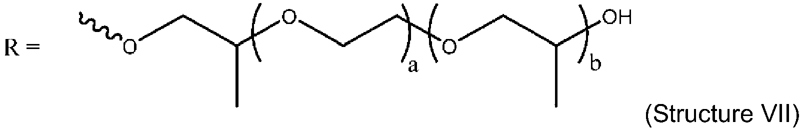 dans laquelle a a une valeur moyenne comprise entre 10 et 14, b a une valeur moyenne comprise entre 12 et 16, le rapport molaire entre motifs PO et motifs EO est compris entre 1:1 et 1,3:1 et la masse moléculaire est comprise entre 6 500 et 7 500 ; 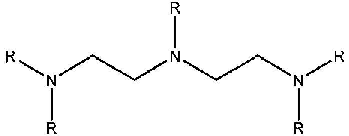 où 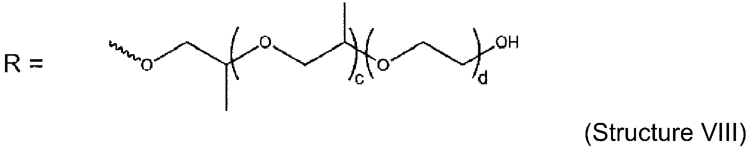 dans laquelle c a une valeur moyenne comprise entre 12 et 16, d a une valeur moyenne comprise entre 10 et 14, le rapport molaire entre motifs PO et motifs EO est compris entre 1,1:1 et 1,3:1, et la masse moléculaire est comprise entre 6 500 et 7 500 ; 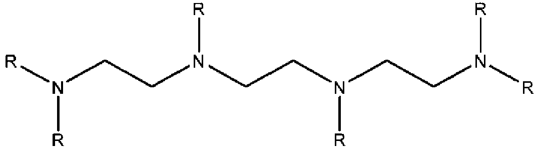 où 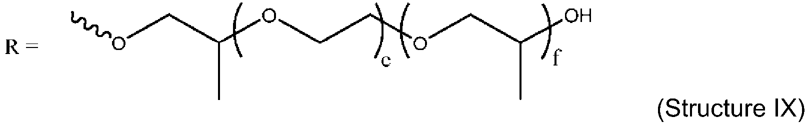 dans laquelle e a une valeur moyenne comprise entre 10 et 14, f a une valeur moyenne comprise entre 6 et 9, le rapport molaire entre motifs PO et motifs EO est compris entre 0,5:1 et 0,7:1, et la masse moléculaire est comprise entre 6 500 et 7 500 ; 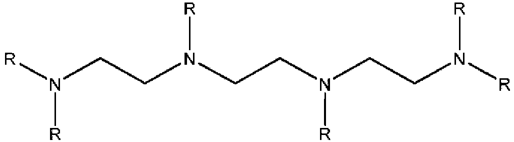 où 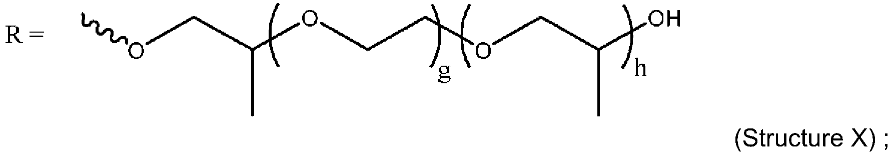 dans laquelle g a une valeur moyenne comprise entre 18 et 24, h a une valeur moyenne comprise entre 9 et 12, le rapport molaire entre motifs PO et motifs EO est compris entre 0,4:1 et 0,7:1, et la masse moléculaire est comprise entre 9 000 et 11 000 ; et 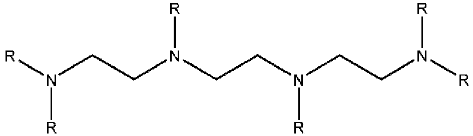 où : 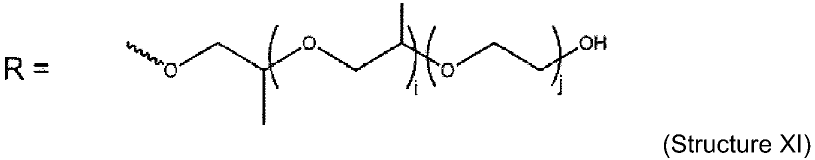 dans laquelle i a une valeur moyenne comprise entre 6 et 9, j a une valeur moyenne comprise entre 14 et 16, le rapport molaire entre motifs PO et motifs EO est compris entre 0,5:1 et 0,7:1, et la masse moléculaire est comprise entre 6 500 et 7 500.

10. Composition selon la revendication 1, dans laquelle ladite composition comprend du bis-(3-sodium sulfopropyl disulfure), ayant l'acronyme SPS, en une concentration comprise entre 35 et 100 mg/L.

11. Composition selon la revendication 10, dans laquelle ledit suppresseur est choisi dans le groupe constitué de : 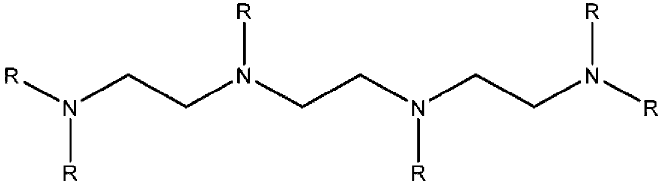 où 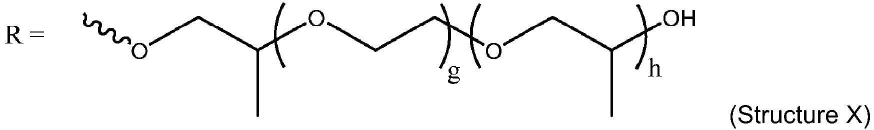 et g a une valeur moyenne comprise entre 18 et 24, h a une valeur moyenne comprise entre 9 et 12, le rapport molaire entre motifs PO et motifs EO est compris entre 0,4:1 et 0,7:1, et la masse moléculaire est comprise entre 6 500 et 7 500 ; 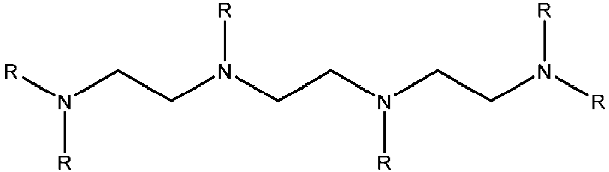 où 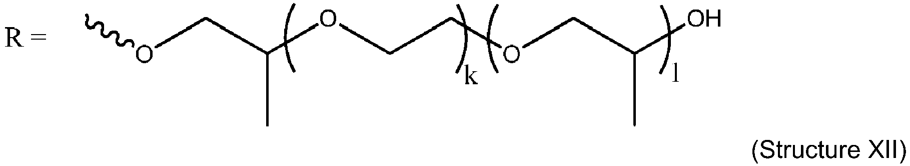 et k a une valeur moyenne comprise entre 15 et 20, l a une valeur moyenne comprise entre 3 et 7, le rapport molaire entre motifs PO et motifs EO est compris entre et 0,25:1 et 0,4:1, et la masse moléculaire est comprise entre 9 000 et 11 000 ; et 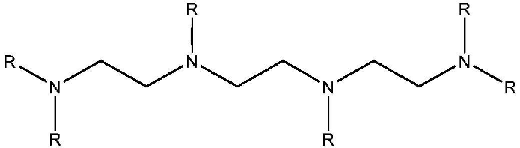 où : 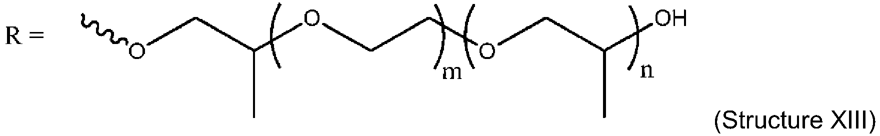 et m a une valeur moyenne comprise entre 10 et 14, n a une valeur moyenne comprise entre 8 et 12, le rapport molaire entre motifs PO et motifs EO est compris entre 0,8:1 et 1,0:1, et la masse moléculaire est comprise entre 6 500 et 7 500.

12. Composition selon la revendication 1, dans laquelle ledit suppresseur est choisi dans le groupe constitué de : 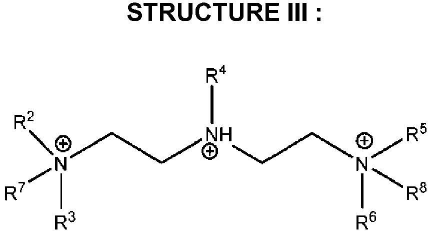 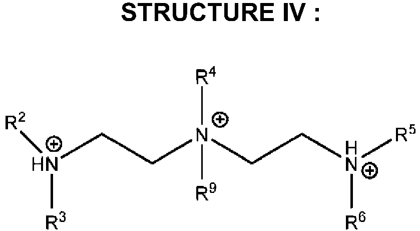 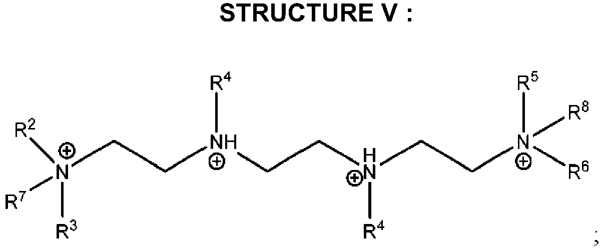 et 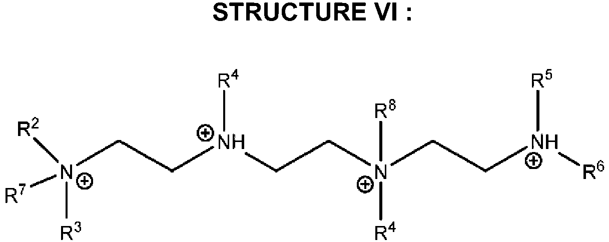 dans laquelle au moins l'un de R², R³, R⁴, R⁵ et R⁶ comprend un substituant de polyéther comprenant un copolymère à blocs d'oxyde de propylène et d'oxyde d'éthylène dans laquelle le rapport entre motifs répétitifs d'oxyde de propylène (PO) et motifs répétitifs d'oxyde d'éthylène (PO) est compris entre 0,25:1 et 1,4:1, chacun du reste de R², R³, R⁴, R⁵ et R⁶ est choisi dans le groupe constitué d'hydrogène, alkyle inférieur, aminoalkyle, hydroxyalkyle et un substituant de polyéther comprenant des motifs répétitifs d'oxyde de propylène (PO), des motifs répétitifs d'oxyde d'éthylène (EO), ou une combinaison de motifs répétitifs PO et EO, chacun de R⁷ et R⁸ est choisi dans le groupe constitué d'alkyle, aryle, aralkyle, alcényle, et un proton, et au moins l'un de R⁷ et R⁸ est autre qu'un proton, R⁹ est choisi dans le groupe constitué d'alkyle, aryle, aralkyle, et alcényle.

13. Composition selon la revendication 3, dans laquelle
(i) le rapport entre motifs répétitifs d'oxyde de propylène (PO) et motifs répétitifs d'oxyde d'éthylène (EO) est compris entre 3:7 et 6:5, facultativement dans laquelle le rapport entre motifs répétitifs d'oxyde de propylène (PO) et motifs répétitifs d'oxyde d'éthylène (EO) est compris entre 1:3 et 1,0:1 ;
(ii) le rapport entre motifs répétitifs d'oxyde de propylène (PO) et motifs répétitifs d'oxyde d'éthylène (EO) est compris entre 4:6 et 6:4 ;
(iii) au moins deux de R², R³, R⁴, R⁵ et R⁶ comprennent des substituants de polyéther, chacun comprenant un copolymère à blocs d'oxyde de propylène et d'oxyde d'éthylène, et le rapport entre motifs répétitifs d'oxyde de propylène (PO) et motifs répétitifs d'oxyde d'éthylène (EO) dans la molécule de suppresseur est compris entre 4:6 et 6:4 ; ou
(iv) au moins deux de R², R³, R⁴, R⁵ et R⁶ comprennent facultativement des substituants polyéther, chacun comprenant un copolymère à blocs d'oxyde de propylène et d'oxyde d'éthylène, et le rapport entre motifs répétitifs d'oxyde de propylène (PO) et motifs répétitifs d'oxyde d'éthylène (EO) dans chaque substituant de polyéther est compris entre 2:8 et 7:3, ou entre 3:7 et 6:5, ou entre 1:3 et 1,0:1, ou entre 4:6 et 6:4.
